# EUROPEAN PATENT APPLICATION

(11) **EP 4 788 093 A1**
(43) Date of publication of application: **05.08.2026**
(21) Application number: 26154964.6
(22) Date of filing: 29.01.2026
(51) Int. Cl.: H10F 39/00, H10F 39/12

(54) **PHOTOELECTRIC CONVERSION APPARATUS AND PHOTOELECTRIC CONVERSION SYSTEM**

(30) Priority: 31.01.2025 JP 2025015069
(71) Applicant: Canon Kabushiki Kaisha, Tokyo, 146-8501 (JP)
(72) Inventor: SEKINE, Hiroshi, Ohta-ku, Tokyo, 146-8501 (JP); MORIMOTO, Kazuhiro, Ohta-ku, Tokyo, 146-8501 (JP)
(74) Representative: TBK

(57) **Abstract**

A photoelectric conversion apparatus includes a semiconductor layer including a first surface and a second surface, a first electrode plug arranged to contact the first surface and supplied with a first voltage, and a second electrode plug arranged to contact the first surface and supplied with a second voltage. The semiconductor layer includes an active region defined by an isolation region so as to have an elongated shape in a predetermined direction in an orthogonal projection onto the first surface. The active region includes a first semiconductor region of a first conductivity type arranged to contact the first electrode plug, and a second semiconductor region of a second conductivity type arranged to contact the second electrode plug. A centroid of the first semiconductor region is arranged between a first end of the active region in the predetermined direction and a centroid of the active region. The second semiconductor region is arranged between a second end of the active region in the predetermined direction and the first semiconductor region.

## Description

### TECHNICAL FIELD

The present disclosure relates to a photoelectric conversion apparatus and a photoelectric conversion system.

### BACKGROUND

Japanese Patent Laid-Open No. 2018-201005 describes an avalanche photodiode (APD) that includes an n-type semiconductor region functioning as a cathode, a p-type semiconductor region forming a p-n junction with the n-type semiconductor region, and an anode arranged in the same layer as and close to the n-type semiconductor region. The p-type semiconductor region includes a multiplication region where carriers generated by incident detected light undergo avalanche multiplication. The APD described in Japanese Patent Laid-Open No. 2018-201005 also includes a contact connected to the n-type semiconductor region functioning as the cathode, an anode arranged in the same layer as the n-type semiconductor region and close to the n-type semiconductor region, and a contact connected to the anode.

In the APD described in Japanese Patent Laid-Open No. 2018-201005, since the cathode and the anode are arranged in the same layer and close to each other, a strong electric field is generated laterally along the surface of a substrate. Therefore, dark charges other than signal charges cause avalanche multiplication, and this can generate noise.

### SUMMARY

The present disclosure provides a technique with a configuration advantageous in noise reduction.

The present disclosure in its first aspect provides a photoelectric conversion apparatus as specified in claim 1, and optional features are specified in claims 2 to 14.

The present disclosure in its second aspect provides a photoelectric conversion system as specified in claim 15.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Fig. 1 is a view showing an example of the arrangement of a photoelectric conversion apparatus according to an embodiment;
Fig. 2 is a view showing an example of the arrangement of the first substrate;
Fig. 3 is a view showing an example of the arrangement of the second substrate;
Fig. 4 is a view showing an example of the arrangement of a photoelectric conversion element and a pixel circuit;
Figs. 5A to 5C are views for explaining a photon detection operation;
Fig. 6 is a view showing an example of the arrangement of a photoelectric conversion apparatus according to the first embodiment;
Fig. 7 is a view showing an example of the arrangement of the photoelectric conversion apparatus according to the first embodiment;
Fig. 8 is a view showing an example of the arrangement of the photoelectric conversion apparatus according to the first embodiment;
Fig. 9 is a view showing an example of the arrangement of the photoelectric conversion apparatus according to the first embodiment;
Fig. 10 is a view showing an example of the arrangement of the photoelectric conversion apparatus according to the first embodiment;
Fig. 11 is a view showing an example of the arrangement of the photoelectric conversion apparatus according to the first embodiment;
Fig. 12 is a view showing an example of the arrangement of the photoelectric conversion apparatus according to the first embodiment;
Fig. 13 is a view showing an example of the arrangement of the photoelectric conversion apparatus according to the first embodiment;
Fig. 14 is a view showing an example of the arrangement of the photoelectric conversion apparatus according to the first embodiment;
Fig. 15 is a view showing an example of the arrangement of a photoelectric conversion apparatus according to the second embodiment;
Fig. 16 is a view showing an example of the arrangement of the photoelectric conversion apparatus according to the second embodiment;
Fig. 17 is a view showing an example of the arrangement of the photoelectric conversion apparatus according to the second embodiment;
Fig. 18 is a view showing an example of the arrangement of the photoelectric conversion apparatus according to the second embodiment;
Fig. 19 is a view showing an example of the arrangement of the photoelectric conversion apparatus according to the second embodiment;
Fig. 20 is a view showing an example of the arrangement of the photoelectric conversion apparatus according to the second embodiment;
Fig. 21 is a view showing an example of the arrangement of the photoelectric conversion apparatus according to a modification of the second embodiment;
Fig. 22 is a view showing an example of the arrangement of a photoelectric conversion apparatus according to the third embodiment;
Fig. 23 is a view showing an example of the arrangement of the photoelectric conversion apparatus according to the third embodiment;
Fig. 24 is a view showing an example of the arrangement of the photoelectric conversion apparatus according to the third embodiment;
Fig. 25 is a view showing an example of the arrangement of the photoelectric conversion apparatus according to the third embodiment;
Fig. 26 is a view showing an example of the arrangement of the photoelectric conversion apparatus according to the third embodiment;
Fig. 27 is a view showing an example of the arrangement of the photoelectric conversion apparatus according to the first modification of the third embodiment;
Fig. 28 is a view showing an example of the arrangement of the photoelectric conversion apparatus according to the first modification of the third embodiment;
Fig. 29 is a view showing an example of the arrangement of the photoelectric conversion apparatus according to the first modification of the third embodiment;
Fig. 30 is a view showing an example of the arrangement of the photoelectric conversion apparatus according to the first modification of the third embodiment;
Fig. 31 is a view showing an example of the arrangement of the photoelectric conversion apparatus according to the first modification of the third embodiment;
Fig. 32 is a potential diagram for explaining an example of the arrangement of the photoelectric conversion apparatus according to the first modification of the third embodiment;
Fig. 33 is a view showing an example of the arrangement of the photoelectric conversion apparatus according to the second modification of the third embodiment;
Fig. 34 is a view showing an example of the arrangement of the photoelectric conversion apparatus according to the second modification of the third embodiment;
Fig. 35 is a view showing an example of the arrangement of the photoelectric conversion apparatus according to the second modification of the third embodiment;
Fig. 36 is a view showing an example of the arrangement of the photoelectric conversion apparatus according to the second modification of the third embodiment;
Fig. 37 is a view showing an example of the arrangement of the photoelectric conversion apparatus according to the second modification of the third embodiment;
Fig. 38 is a view showing an example of the arrangement of a photoelectric conversion apparatus according to the fourth embodiment;
Fig. 39 is a view showing an example of the arrangement of the photoelectric conversion apparatus according to the fourth embodiment;
Fig. 40 is a view showing an example of the arrangement of the photoelectric conversion apparatus according to the fourth embodiment;
Fig. 41 is a view showing an example of the arrangement of the photoelectric conversion apparatus according to the fourth embodiment;
Fig. 42 is a view showing an example of the arrangement of the photoelectric conversion apparatus according to the fourth embodiment;
Fig. 43 is a view showing an example of the arrangement of the photoelectric conversion apparatus according to the first modification of the fourth embodiment;
Fig. 44 is a view showing an example of the arrangement of the photoelectric conversion apparatus according to the first modification of the fourth embodiment;
Fig. 45 is a view showing an example of the arrangement of the photoelectric conversion apparatus according to the first modification of the fourth embodiment;
Fig. 46 is a view showing an example of the arrangement of the photoelectric conversion apparatus according to the first modification of the fourth embodiment;
Fig. 47 is a view showing an example of the arrangement of the photoelectric conversion apparatus according to the second modification of the fourth embodiment;
Fig. 48 is a view showing an example of the arrangement of a photoelectric conversion apparatus according to the fifth embodiment;
Fig. 49 is a view showing an example of the arrangement of the photoelectric conversion apparatus according to the fifth embodiment;
Fig. 50 is a view showing an example of the arrangement of the photoelectric conversion apparatus according to the fifth embodiment;
Fig. 51 is a view showing an example of the arrangement of the photoelectric conversion apparatus according to the fifth embodiment;
Fig. 52 is a view showing an example of the arrangement of the photoelectric conversion apparatus according to the fifth embodiment;
Fig. 53 is a view showing an example of the arrangement of the photoelectric conversion apparatus according to a modification of the fifth embodiment;
Fig. 54 is a view showing an example of the arrangement of the photoelectric conversion apparatus according to the modification of the fifth embodiment;
Fig. 55 is a view showing an example of the arrangement of the photoelectric conversion apparatus according to the modification of the fifth embodiment;
Fig. 56 is a view showing an example of the arrangement of the photoelectric conversion apparatus according to the modification of the fifth embodiment;
Fig. 57 is a functional block diagram of a photoelectric conversion system according to the first application example;
Figs. 58A and 58B are functional block diagrams of a photoelectric conversion system according to the second application example;
Fig. 59 is a functional block diagram of a photoelectric conversion system according to the third application example;
Fig. 60 is a functional block diagram of a photoelectric conversion system according to the fourth application example;
Figs. 61A and 61B are functional block diagrams of a photoelectric conversion system according to the fifth application example;
Figs. 62A and 62B are functional block diagrams of a photoelectric conversion system according to the sixth application example; and
Fig. 63 is a functional block diagram of a photoelectric conversion system according to the seventh application example.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

In this specification, conductivity types of semiconductor regions different from each other are distinguished as the first conductivity type and the second conductivity type. The first conductivity type is a conductivity type which uses charge with the first polarity as a majority carrier, and the second conductivity type is a conductivity type which uses charge with the second polarity as a majority carrier. In a case where the first polarity is positive, the charge with the first polarity is a hole, the first conductivity type is the p type, the second polarity is negative, the charge with the second polarity is an electron, and the second conductivity type is the n type. To the contrary, in a case where the first polarity is negative, the charge with the first polarity is an electron, the first conductivity type is the n type, the second polarity is positive, the charge with the second polarity is a hole, and the second conductivity type is the p type.

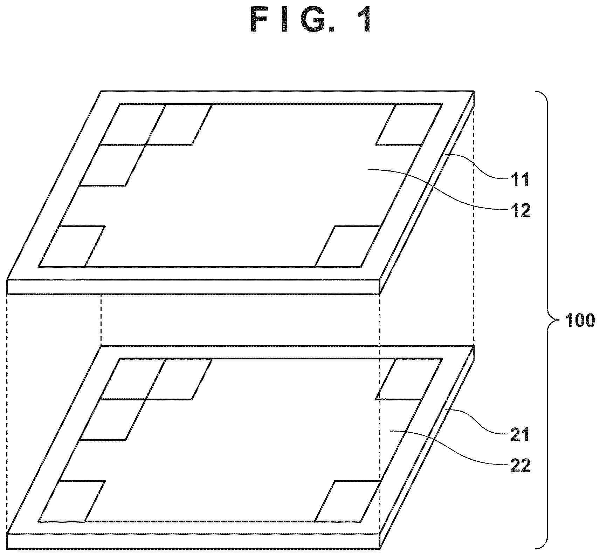

Fig. 1 schematically shows an example of the arrangement of a photoelectric conversion apparatus 100 according to an embodiment of the present disclosure. The photoelectric conversion apparatus 100 can have, for example, a structure in which a first substrate 11 and a second substrate 21 are stacked. The first substrate 11 can include, for example, a photoelectric conversion element array 12 including a plurality of photoelectric conversion elements (APDs). The second substrate 21 can include a processing circuit 22 that processes signals output from the plurality of photoelectric conversion elements.

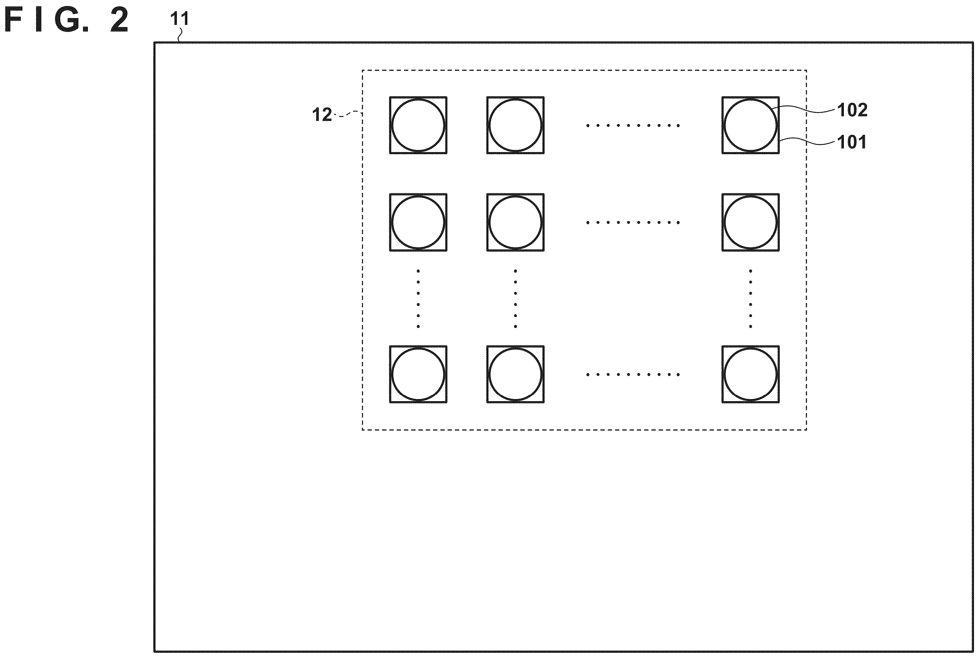

Fig. 2 schematically shows an example of the arrangement of the first substrate 11. The photoelectric conversion element array 12 of the first substrate 11 can include a plurality of photoelectric conversion elements 102 arranged to form a plurality of rows and a plurality of columns. Each photoelectric conversion element 102 constitutes a part of a pixel 101. The photoelectric conversion apparatus 100 will exemplarily be described below as an image capturing apparatus. However, the photoelectric conversion apparatus 100 may be formed as another apparatus. For example, the photoelectric conversion apparatus 100 can be formed as a distance measurement apparatus (for example, a focus detection apparatus or a distance measurement apparatus using TOF (Time Of Flight)) or a photometric apparatus (an apparatus for, for example, measuring an incident light amount). Note that a plurality of pixels 101 may linearly be arranged. In this case, the photoelectric conversion apparatus 100 can form a line sensor.

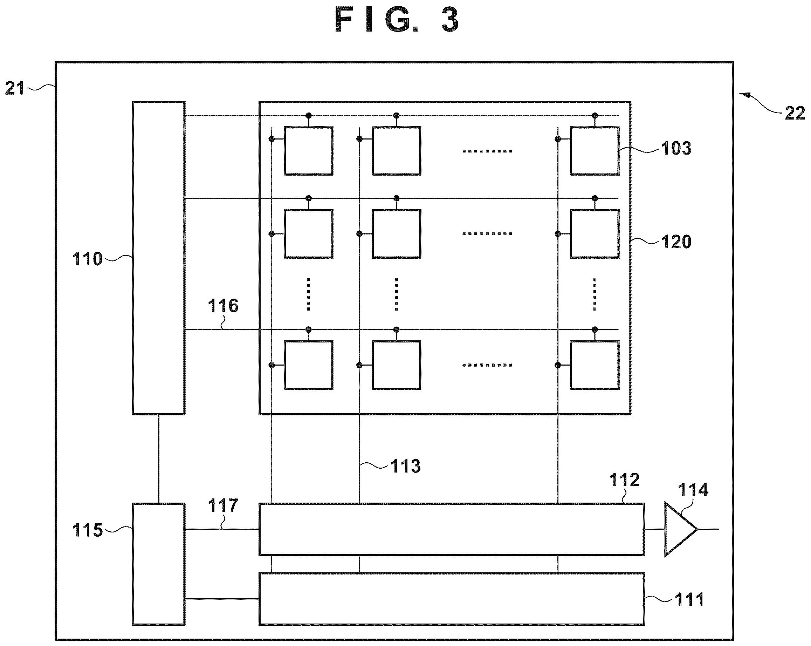

Fig. 3 schematically shows the arrangement of the processing circuit 22 of the second substrate 21. The processing circuit 22 can include, for example, a pixel circuit array 120 including a plurality of pixel circuits 103, a readout circuit 112, a control unit 115, a horizontal scanning circuit 111, a plurality of signal lines 113, a vertical scanning circuit 110, and an output unit 114. Each pixel circuit 103 constitutes the pixel 101 together with the corresponding photoelectric conversion element 102, and processes a signal output from the photoelectric conversion element 102. One pixel circuit 103 may be provided for one photoelectric conversion element 102, or one pixel circuit 103 may be provided for two or more photoelectric conversion elements 102. In an example, one photoelectric conversion element 102 and one pixel circuit 103 can electrically be connected by a connection portion. The pixel circuit 103 can include, for example, a counter and a memory. The memory can hold a count value obtained by counting by the counter. The photoelectric conversion element array 12 and the pixel circuit array 120 constitute a pixel array.

For example, the vertical scanning circuit 110 can sequentially select a plurality of rows of the photoelectric conversion element array 12 in accordance with a control signal supplied from the control unit 115. The vertical scanning circuit 110 can include, for example, at least one of a shift register and an address decoder. The readout circuit 112 reads out signals output, via the plurality of signal lines 113, from the pixel circuits 103 corresponding to the pixels 101 of the row selected by the vertical scanning circuit 110. For example, the horizontal scanning circuit 111 supplies to the output unit 114, in a predetermined order, the signals for one row read out by the readout circuit 112.

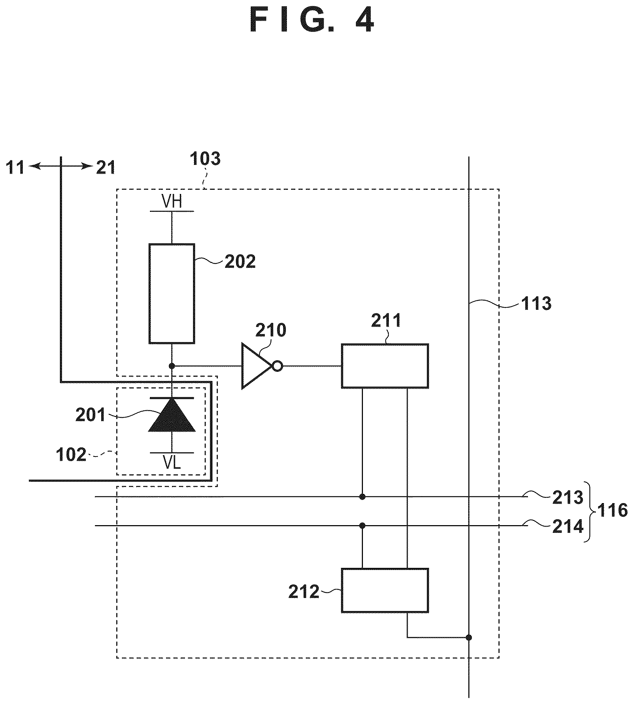

Fig. 4 shows an example of the arrangement of the photoelectric conversion element 102 and the pixel circuit 103. In the example shown in Fig. 4, one pixel circuit 103 is assigned to one photoelectric conversion element 102. The photoelectric conversion element 102 includes an APD 201. At least one of a plurality of components of the pixel circuit 103 may be arranged on the first substrate 11. Alternatively, all the plurality of components of the pixel circuit 103 may be arranged on the first substrate 11.

A first voltage VH can be applied to the cathode of the APD 201. A second voltage VL is applied to the anode of the APD 201, and the first voltage VH has a potential higher than the potential of the second voltage VL. A potential difference between the first voltage VH and the second voltage VL is applied to the APD 201 (between the anode and cathode of the APD 201). This potential difference is a reverse bias voltage that causes the APD 201 to perform an avalanche multiplication operation. Charges generated by photons entering the APD 201 cause avalanche multiplication, thereby generating an avalanche current. A mode of applying a voltage higher than the breakdown voltage of the APD 201 between the anode and cathode of the APD 201 is called a Geiger mode. A mode of applying a voltage around or lower than the breakdown voltage between the anode and cathode of the APD 201 is called a linear mode. An APD operating in the Geiger mode is called an SPAD. In an example, the first voltage VH is 1 V, and the second voltage VL is - 30 V.

The pixel circuit 103 can include a quenching element 202 connected between the cathode of the APD 201 and a terminal supplied with the first voltage VH. The quenching element 202 may be understood as an element that supplies the first voltage VH to the cathode of the APD 201. The quenching element 202 has a function of converting the change of the avalanche current generated in the APD 201 into a voltage signal. The quenching element 202 functions as a load circuit (quenching circuit) at the time of signal multiplication by avalanche multiplication, and serves to suppress avalanche multiplication by suppressing the voltage applied to the APD 201. This is known as a quenching operation.

The pixel circuit 103 can additionally include, for example, at least one of a waveform shaping unit 210, a counter circuit 211, and a selection circuit 212. The waveform shaping unit 210 can output a pulse signal by shaping the potential change of the cathode of the APD 201 at the time of detection of a photon. The waveform shaping unit 210 can include, for example, an inverter circuit. In the example shown in Fig. 4, the waveform shaping unit 210 is formed by one inverter, but the waveform shaping unit 210 may be formed by series-connecting a plurality of inverters or by another circuit having the waveform shaping effect.

The counter circuit 211 can be configured to count a pulse signal output from the waveform shaping unit 210 and hold a count value obtained by counting. When a first control pulse of an active level is supplied from the vertical scanning circuit 110 via a driving line 213, the signal held in the counter circuit 211 can be reset. When a second control pulse of an active level is supplied from the vertical scanning circuit unit 110 via a driving line 214, the selection circuit 212 can electrically connect the counter circuit 211 and the signal line 113. The selection circuit 212 can include, for example, a buffer circuit.

In this example, the counter circuit 211 is provided. However, the photoelectric conversion apparatus 100 may be configured to acquire a pulse detection timing by providing a Time-to-Digital Converter (to be referred to as a TDC hereinafter), instead of the counter circuit 211. In this case, the generation timing of the pulse signal output from the waveform shaping unit 210 can be converted into a digital signal by the TDC. A reference pulse (reference signal) can be supplied from the vertical scanning circuit unit 110 to the TDC via a driving line to measure the timing of the pulse signal. With reference to the reference pulse, the TDC can generate a digital signal corresponding to the generation timing of the pulse signal output from the waveform shaping unit 210.

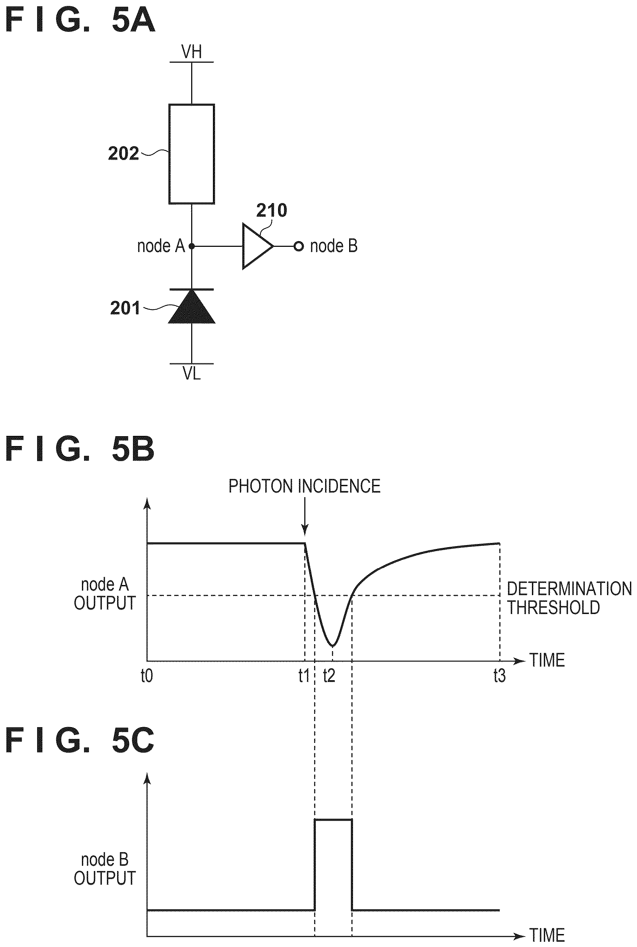

Figs. 5A to 5C are views for explaining a photon detection operation by the photoelectric conversion apparatus 100. Fig. 5A is a view showing an excerpt of the APD 201, the quenching element 202, and the waveform shaping unit 210 from Fig. 4. The input side of the waveform shaping unit 210 is a node A and the output side of the waveform shaping unit 210 is a node B. Fig. 5B shows the waveform at the node A of Fig. 5A and Fig. 5C shows the waveform at the node B of Fig. 5A. From time t0 to time t1, a potential difference of VH - VL is applied to the APD 201. When a photon enters at time t1, avalanche multiplication occurs in the APD 201. This causes an avalanche multiplication current to flow into the quenching element 202, and the voltage (potential) of the node A drops. When the voltage drop amount increases and the potential difference applied to the APD 201 decreases, the avalanche multiplication of the APD 201 stops. After that, a current compensating for the voltage drop from the voltage VL flows into the node A, and the node A settles at the original potential level at time t3. At this time, a portion at which the output waveform exceeds a given threshold at the node A is waveform-shaped by the waveform shaping unit 210 and a pulse signal appears at the node B.

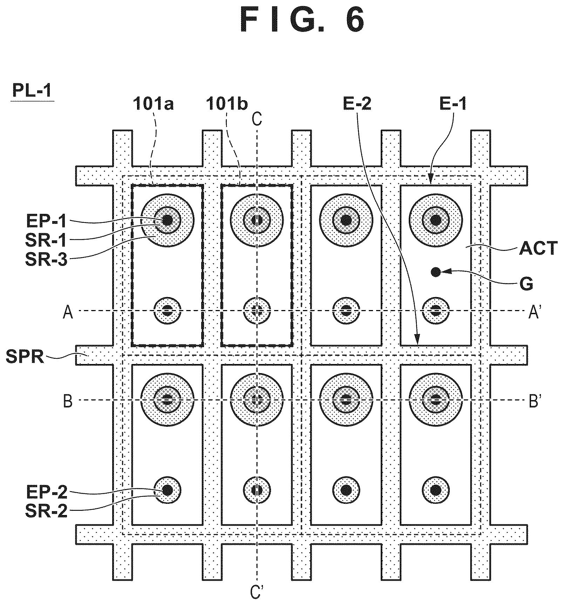

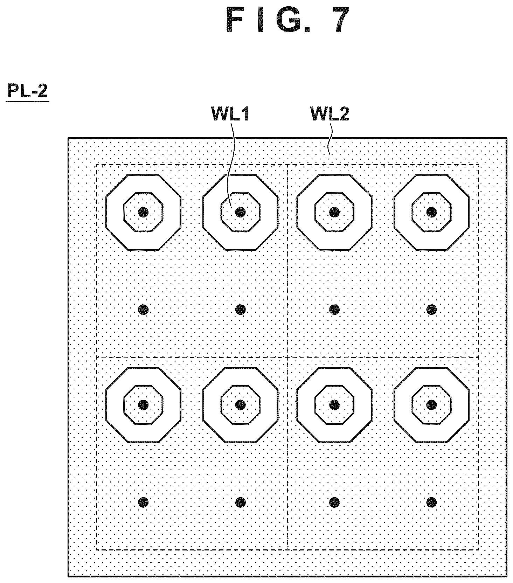

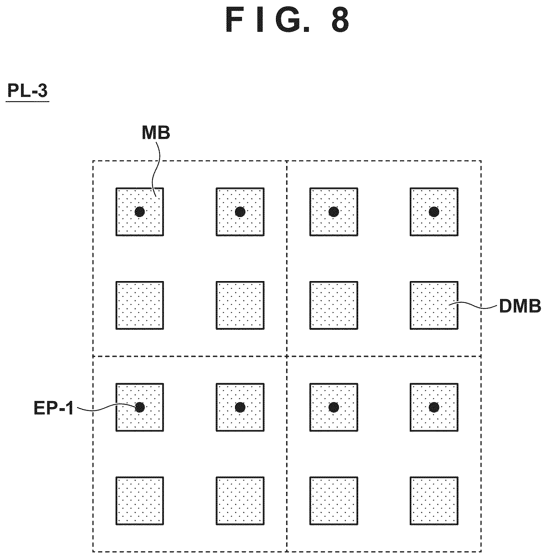

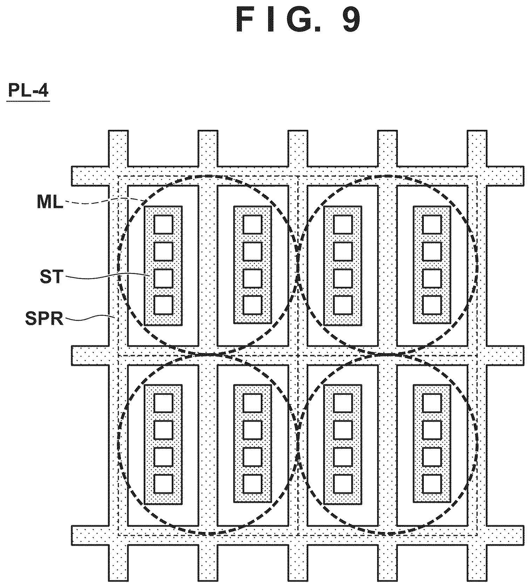

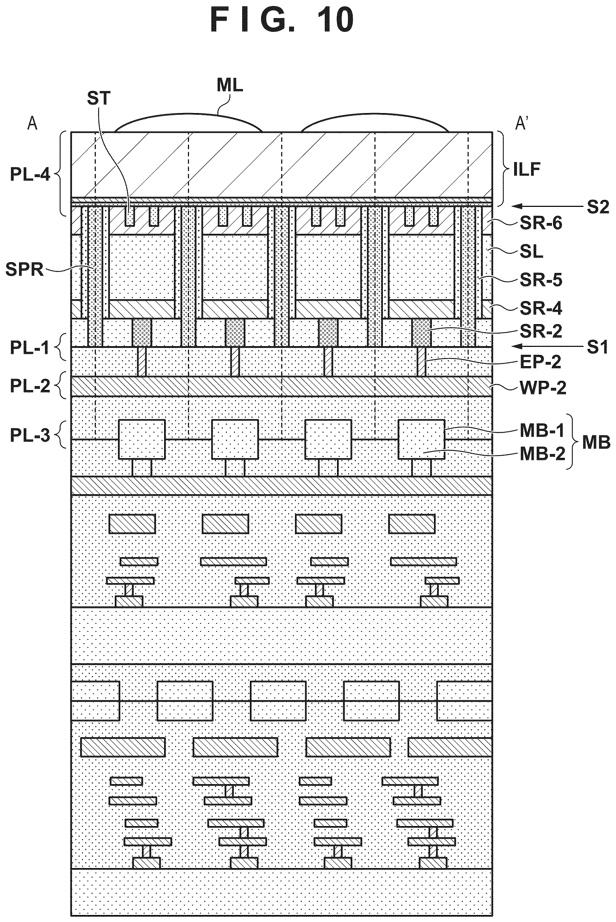

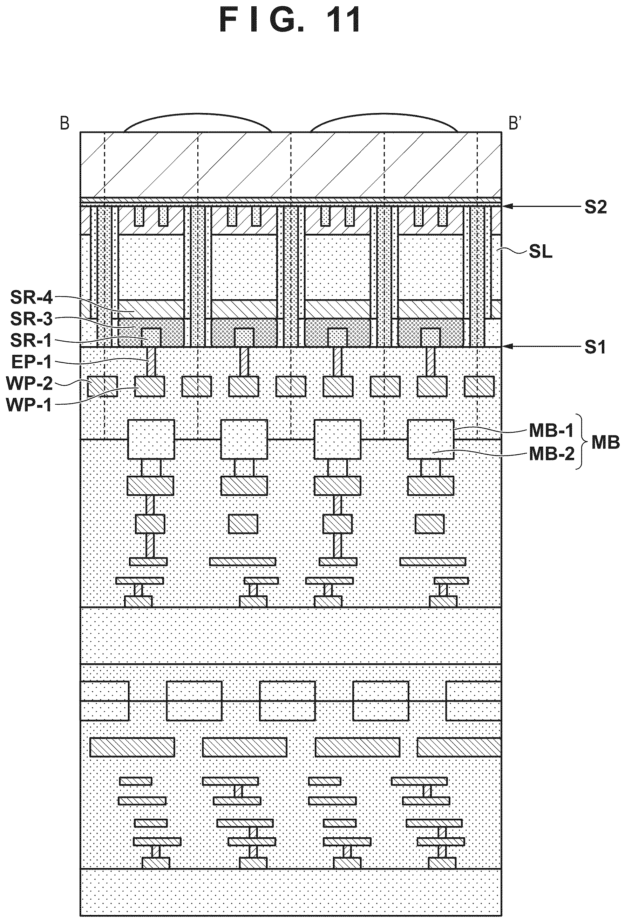

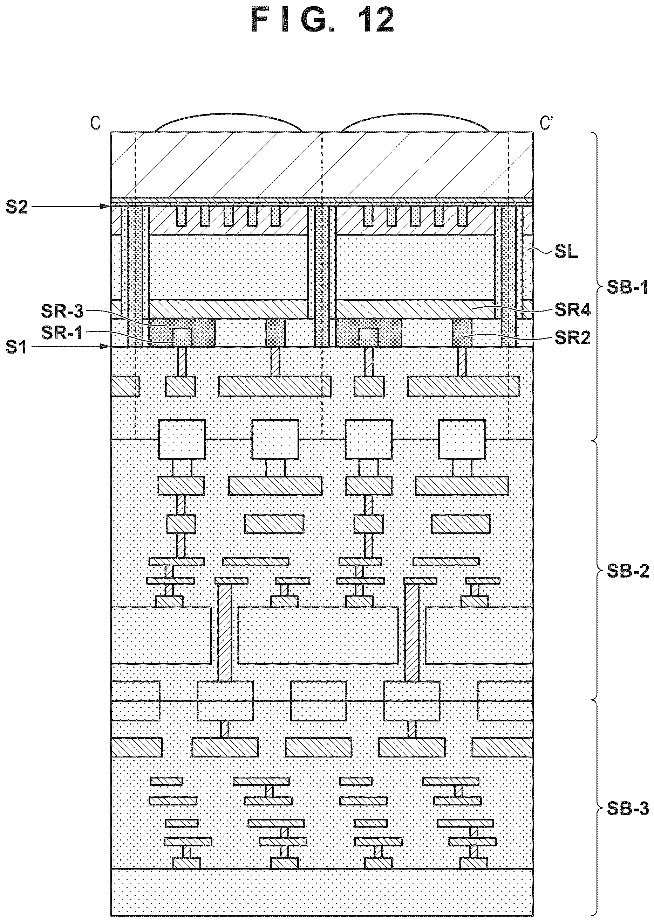

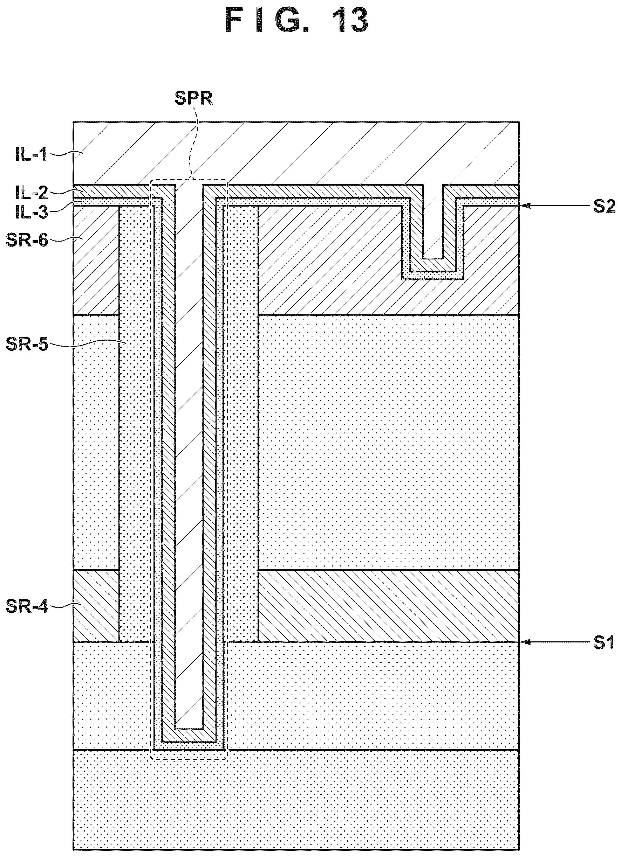

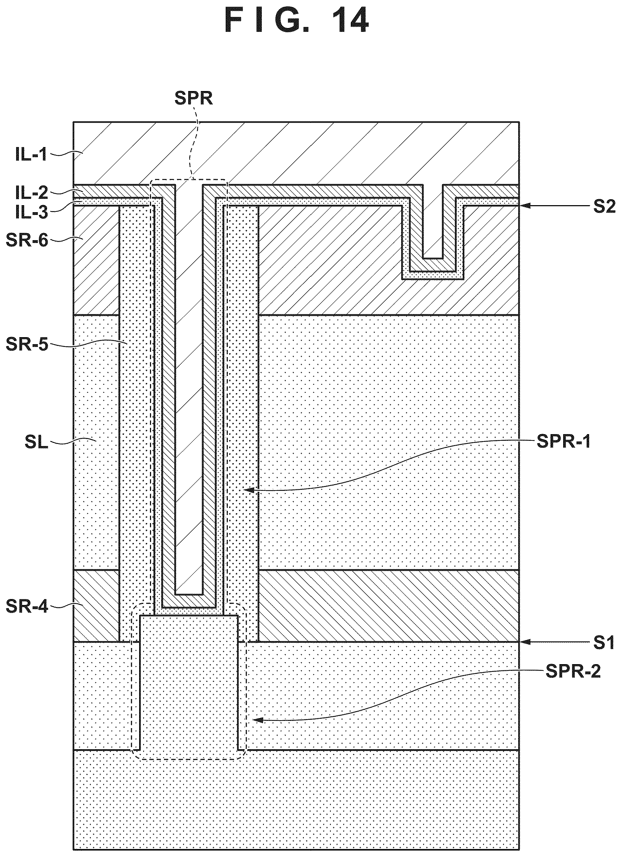

With reference to Figs. 6 to 14, a photoelectric conversion apparatus 100 according to the first embodiment will be described below. Fig. 6 shows the schematic planar view of the photoelectric conversion apparatus 100 in a first plane PL-1. Fig. 7 shows the schematic planar view of the photoelectric conversion apparatus 100 in a second plane PL-2. Fig. 8 shows the schematic planar view of the photoelectric conversion apparatus 100 in a third plane PL-3. Fig. 9 shows the schematic planar view of the photoelectric conversion apparatus 100 in a fourth plane PL-4. A planar view is an orthogonal projection onto a first surface S1 or a second surface S2 of a semiconductor layer SL to be described later. Fig. 10 is a schematic sectional view of the photoelectric conversion apparatus 100 taken along a line A - A' in Fig. 6. Fig. 11 is a schematic sectional view of the photoelectric conversion apparatus 100 taken along a line B - B' in Fig. 6. Fig. 12 is a schematic sectional view of the photoelectric conversion apparatus 100 taken along a line C - C' in Fig. 6. Fig. 13 is a schematic sectional view showing the arrangement of an isolation region SPR. Fig. 14 is a schematic sectional view showing the arrangement of a modification of the isolation region SPR.

Fig. 6 illustrates a first semiconductor region SR-1 of the first conductivity type, a second semiconductor region SR-2 of the second conductivity type, a third semiconductor region SR-3 of the first conductivity type, an active region ACT, and the isolation region SPR. Fig. 6 also illustrates a first electrode plug EP-1 to which the first voltage VH is applied, and a second electrode plug EP-2 to which the second voltage VL is applied. The impurity concentration of the first conductivity type in the third semiconductor region SR-3 is lower than the impurity concentration of the first conductivity type in the first semiconductor region SR-1. Accordingly, the third semiconductor region SR-3 can function to relax the electric field between the first semiconductor region SR-1 and the second semiconductor region SR-2. The active region ACT can have an elongated shape in a predetermined direction, for example, a shape such as a rectangle with a long side and a short side, a rhombus, a parallelogram, a trapezoid, or an oval. An elongated shape in a predetermined direction means a shape where the dimension in the predetermined direction is larger than the dimension in a direction orthogonal to the predetermined direction. The predetermined direction may be understood as the longitudinal direction of the active region ACT. The length of the active region ACT in the predetermined direction can be, for example, in a range of 1.5 times (inclusive) to 2.5 times (inclusive) the length of the active region in the direction orthogonal to the predetermined direction, and preferably in a range of 1.8 times (inclusive) to 2.2 times (inclusive) thereof. The active region ACT can include the first semiconductor region SR-1 of the first conductivity type arranged to contact the first electrode plug EP-1, and the second semiconductor region SR-2 of the second conductivity type arranged to contact the second electrode plug EP-2. The active region ACT can also include the third semiconductor region SR-3 of the first conductivity type arranged to surround the first semiconductor region SR-1 of the first conductivity type.

The active region ACT can be defined by the isolation region SPR. The isolation region SPR can be arranged to surround the active region ACT. The isolation region SPR can include, for example, a Deep Trench Isolation (DTI). The DTI can include an insulator such as silicon oxide, aluminum oxide, or tantalum oxide. The centroid of the first semiconductor region SR-1 can be arranged between a first end E-1 of the active region ACT in the predetermined direction and a centroid G of the active region ACT, and the second semiconductor region SR-2 can be arranged between a second end E-2 of the active region ACT in the predetermined direction and the first semiconductor region SR-1. From another viewpoint, in the planar view, the centroid of the first electrode plug EP-1 can be arranged between the first end E-1 of the active region ACT and the centroid G of the active region ACT, and the second electrode plug EP-2 can be arranged between the second end E-2 of the active region ACT and the first electrode plug EP-1. This arrangement is advantageous for increasing the distance between the first semiconductor region SR-1 and the second semiconductor region SR-2 in the active region ACT having the elongated shape in the predetermined direction. This can reduce the possibility of noise occurring due to avalanche multiplication that is caused by dark charges other than signal charges between the first semiconductor region SR-1 and the second semiconductor region SR-2.

The first semiconductor region SR-1 can be arranged to fit in one of two regions obtained by dividing the active region ACT, which has an elongated shape in a predetermined direction, equally in the predetermined direction. In an example, the centroid G of the first semiconductor region SR-1 can be arranged to match the center of one of two regions obtained by dividing the active region ACT equally in the predetermined direction.

Fig. 7 illustrates a first wiring pattern WL-1 for supplying the first voltage VH to the first electrode plug EP-1, and a second wiring pattern WL-2 for supplying the second voltage VL to the second electrode plug EP-2.

Fig. 8 illustrates a joint structure MB including a first joint portion MB-1 electrically connected to the first electrode plug EP-1, and a second joint portion MB-2 joined to the first joint portion MB-1. In Fig. 8, a black circle indicates the first electrode plug EP-1. As will be described later, the first joint portion MB-1 is arranged on the first substrate SB-1, and the second joint portion MB-2 is arranged on the second substrate SB-2. In the planar view, the first joint portion MB-1 and the second joint portion MB-2 preferably overlap the first semiconductor region SR-1. This arrangement is advantageous for reducing the parasitic capacitance of a node electrically connected to the first semiconductor region SR-1, and this can contribute to reduction of power consumption and improvement of image quality. The joint structures MB are preferably arranged at the same density across the entire photoelectric conversion element array 12 in the planar view. To achieve this, a dummy joint structure DMB can be arranged at a position where the first electrode plug EP-1 does not exist. This is advantageous for improving the stability in a bonding step between the first substrate SB-1 and the second substrate SB-2.

Fig. 9 illustrates a microlens ML, an optical structure ST that scatters and/or diffracts light, and the isolation region SPR. Each microlens ML can be provided for two photoelectric conversion elements 102. This structure is advantageous for focus detection based on phase difference detection. The optical structure ST can be formed by, for example, forming a recess portion in the semiconductor (silicon) constituting the semiconductor layer SL and filling the recess portion with a light transmitting material, such as silicon oxide, having a refractive index different from the refractive index of the semiconductor. By providing the optical structure ST, the optical path length of light propagating through the semiconductor layer SL can be increased, thereby improving the sensitivity of the photoelectric conversion apparatus 100 in a near-infrared wavelength range.

Fig. 10 illustrates the semiconductor layer SL including the first surface S1 and the second surface S2. In the active region ACT of the semiconductor layer SL, the second semiconductor region SR-2 of the second conductivity type, a fourth semiconductor region SR-4 of the second conductivity type, a fifth semiconductor region SR-5 of the second conductivity type, a sixth semiconductor region SR-6 of the second conductivity type, the isolation region SPR, and the optical structure ST are arranged. Fig. 10 further illustrates an insulating layer ILF and the microlenses ML. Fig. 10 further illustrates the first plane PL-1, the second plane PL-2, the third plane PL-3, and the fourth plane PL-4. The fifth semiconductor region SR-5 can be arranged to contact the isolation region SPR, thereby suppressing generation of a dark charge from the interface between the isolation region SPR and the semiconductor constituting the semiconductor layer SL. The fifth semiconductor region SR-5 can be arranged to surround the fourth semiconductor region SR-4. The sixth semiconductor region SR-6 can be arranged between the fourth semiconductor region SR-4 and the second surface S2 and spaced apart from the fourth semiconductor region SR-4. From another viewpoint, the sixth semiconductor region SR-6 can be arranged to contact the second surface S2 of the semiconductor layer SL. The sixth semiconductor region SR-6 can suppress generation of a dark charge from the second surface S2 of the semiconductor layer SL.

Here, the impurity concentration of the second conductivity type in the second semiconductor region SR-2 may be higher than the impurity concentration of the second conductivity type in each of the fifth semiconductor region SR-5 and the sixth semiconductor region SR-6. The impurity concentration of the second conductivity type in each of the fifth semiconductor region SR-5 and the sixth semiconductor region SR-6 may be similar to the impurity concentration of the second conductivity type in the fourth semiconductor region SR-4, or may be higher than the impurity concentration of the second conductivity type in the fourth semiconductor region SR-4. The second voltage VL can be supplied to the second semiconductor region SR-2 of the second conductivity type, the fourth semiconductor region SR-4 of the second conductivity type, the fifth semiconductor region SR-5 of the second conductivity type, and the sixth semiconductor region SR-6 of the second conductivity type.

Fig. 11 illustrates the first semiconductor region SR-1 of the first conductivity type, the third semiconductor region SR-3 of the first conductivity type, and the fourth semiconductor region SR-4 of the second conductivity type arranged in the active region ACT of the semiconductor layer SL. The fourth semiconductor region SR-4 is arranged between the third semiconductor region SR-3 and the second surface S2. The fourth semiconductor region SR-4 is electrically connected to the second semiconductor region SR-2. Between the first semiconductor region SR-1 of the first conductivity type and the fourth semiconductor region SR-4 of the second conductivity type, a strong electric field is generated, and an avalanche multiplication region is formed. Fig. 12 illustrates the first semiconductor region SR-1 of the first conductivity type, the second semiconductor region SR-2 of the second conductivity type, the third semiconductor region SR-3 of the first conductivity type, and the fourth semiconductor region SR-4 of the second conductivity type arranged in the semiconductor layer SL. As illustrated in Fig. 12, the photoelectric conversion apparatus 100 may include, for example, a third substrate SB-3 in addition to the first substrate SB-1 and the second substrate SB-2.

The impurity concentration of the first conductivity type in the first semiconductor region SR-1 may be 1 × 10¹⁸ cm⁻³ or more, and may be 3 × 10¹⁹ cm⁻³ or less. In an example, the impurity concentration of the first conductivity type in the first semiconductor region SR-1 is 1 × 10¹⁹ cm⁻³. The impurity concentration of the first conductivity type in the third semiconductor region SR-3 may be 1 × 10¹⁵ cm⁻³ or more, and may be less than 1 × 10¹⁸ cm⁻³. In an example, the impurity concentration of the first conductivity type in the third semiconductor region SR-3 is 1 × 10¹⁷ cm⁻³ or more.

The impurity concentration of the second conductivity type in the second semiconductor region SR-2 may be 1 × 10¹⁸ cm⁻³ or more, and may be 6 × 10¹⁹ cm⁻³ or less. In an example, the impurity concentration of the second conductivity type in the second semiconductor region SR-2 can be 4 × 10¹⁹ cm⁻³. The impurity concentration of the second conductivity type in the fourth semiconductor region SR-4 may be 1 × 10¹⁵ cm⁻³ or more, and may be less than 1 × 10¹⁸ cm⁻³. In an example, the impurity concentration of the second conductivity type in the fourth semiconductor region SR-4 can be 4 × 10¹⁶ cm⁻³. The impurity concentration of the second conductivity type in the fifth semiconductor region SR-5 may be 1 × 10¹⁵ cm⁻³ or more, and may be less than 1 × 10¹⁸ cm⁻³. In an example, the impurity concentration of the second conductivity type in the fifth semiconductor region SR-5 can be 3 × 10¹⁶ cm⁻³. The impurity concentration of the second conductivity type in the sixth semiconductor region SR-6 may be 1 × 10¹⁶ cm⁻³ or more, and may be within a range of 1 × 10¹⁷ cm⁻³.

As illustrated in Figs. 6 and 9, the plurality of pixels 101 of the photoelectric conversion apparatus 100 can form a plurality of sets such that two adjacent pixels (for example, pixels 101a and 101b) form one set. A plurality of microlenses ML can be provided to correspond to the plurality of sets, respectively. Each pixel 101 (for example, the pixel 101a) includes one active region ACT including the first semiconductor region SR-1 and the second semiconductor region SR-2. The plurality of sets can be arranged to form, for example, a square grid. Alternatively, the plurality of sets may be arranged to form, for example, a rectangular grid.

In the first embodiment, a direction from the first semiconductor region SR-1 of the first pixel 101a toward the second semiconductor region SR-2 of the first pixel 101a matches a direction from the first semiconductor region SR-1 of the second pixel 101b toward the second semiconductor region SR-2 of the second pixel 101b. The pixels 101a and 101b adjacent to each other are used in a pupil division phase difference detection method to detect a phase difference.

As schematically shown in Fig. 13, the isolation region SPR can include a first insulating film IL-1, a second insulating film IL-2, and a third insulating film IL-3. The second insulating film IL-2 is arranged between the first insulating film IL-1 and the third insulating film IL-3. For example, the first insulating film IL-1 can be made of an insulator such as silicon oxide, silicon nitride, or silicon oxynitride. For example, the second insulating film IL-2 and the third insulating film IL-3 can be made of aluminum oxide, tantalum oxide, or the like that induces a charge with the second polarity. From another viewpoint, the second insulating film IL-2 and the third insulating film IL-3 can form a pinning film. This structure is advantageous for electrically separating the adjacent pixels 101 and suppressing generation of a dark charge.

Fig. 14 shows another example of the arrangement of the isolation region SPR. In the arrangement example shown in Fig. 14, the isolation region SPR can include a first isolation region SPR-1 extending from the second surface S2 toward the first surface S1, and a second isolation region SPR-2 extending from the first surface S1 toward the first isolation region SPR-1. The first isolation region SPR-1 includes the second insulating film IL-2 and the third insulating film IL-3 that function as a pinning film, and the second isolation region SPR-2 does not include a pinning film. According to this arrangement, a charge with the second polarity is induced in the interface between the first isolation region SPR-1 and the semiconductor constituting the semiconductor layer SL, but a charge with the second polarity is not induced in the interface between the second isolation region SPR-2 and the semiconductor constituting the semiconductor layer SL. When such a charge is induced, this means that the second voltage VL supplied to the fourth semiconductor region SR-4 is also supplied to a part of the side surface of the isolation region SPR. In this case, a strong electric field can be generated locally between the first semiconductor region SR-1 and the side surface of the isolation region SPR. Therefore, as shown in Fig. 14, the arrangement where a pinning film is not provided in the second isolation region SPR-2 which is a region of the isolation region SPR on the first surface S1 side is useful.

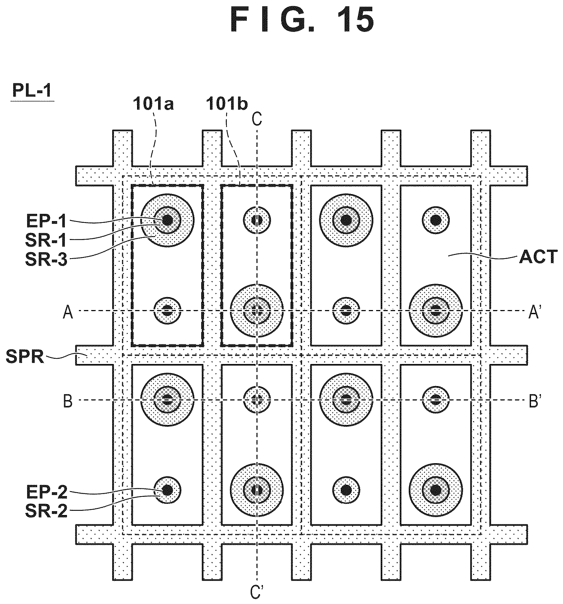

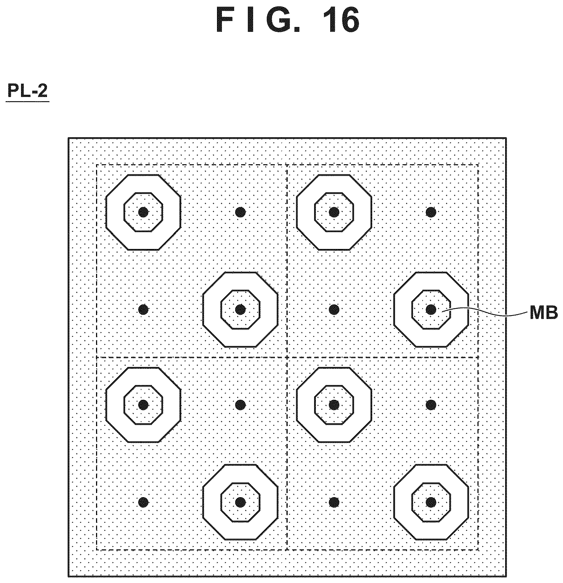

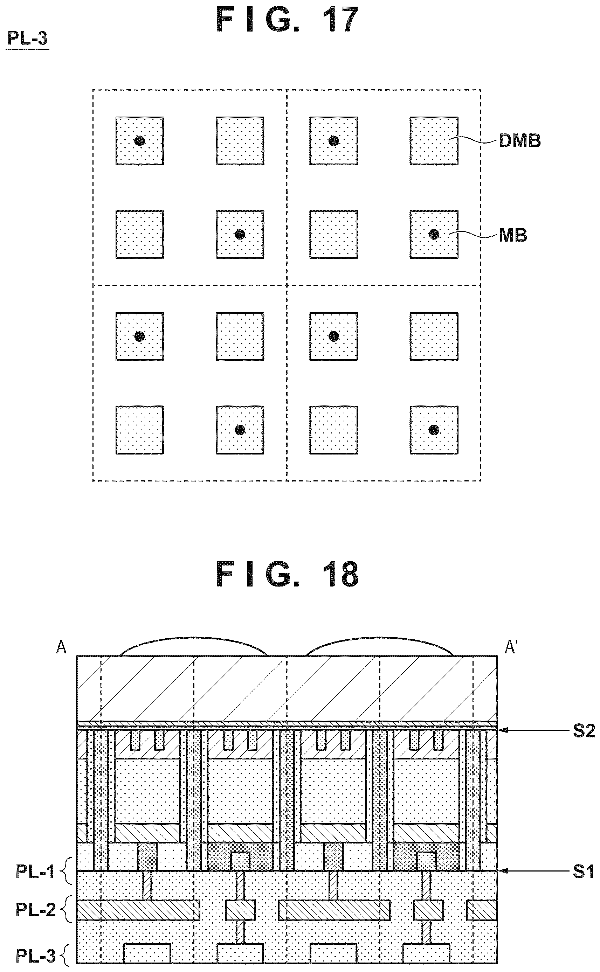

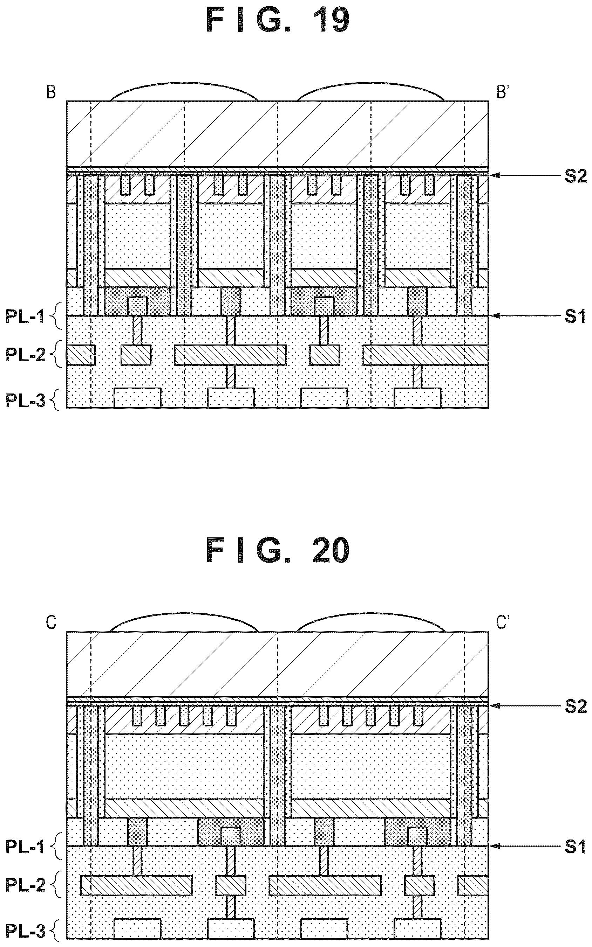

With reference to Figs. 15 to 20, a photoelectric conversion apparatus 100 according to the second embodiment will be described below. Matters not mentioned for the photoelectric conversion apparatus 100 according to the second embodiment can follow the first embodiment. Fig. 15 shows the schematic planar view of the photoelectric conversion apparatus 100 in a first plane PL-1. Fig. 16 shows the schematic planar view of the photoelectric conversion apparatus 100 in a second plane PL-2. Fig. 17 shows the schematic planar view of the photoelectric conversion apparatus 100 in a third plane PL-3. Fig. 18 is a schematic sectional view of the photoelectric conversion apparatus 100 taken along a line A - A' in Fig. 15. Fig. 19 is a schematic sectional view of the photoelectric conversion apparatus 100 taken along a line B - B' in Fig. 15. Fig. 20 is a schematic sectional view of the photoelectric conversion apparatus 100 taken along a line C - C' in Fig. 15.

In the second embodiment, a direction from a first semiconductor region SR-1 of a first pixel 101a toward a second semiconductor region SR-2 of the first pixel 101a and a direction from the first semiconductor region SR-1 of a second pixel 101b toward the second semiconductor region SR-2 of the second pixel 101b are opposite each other. According to this arrangement, the difference among the distance between the first semiconductor region SR-1 and the first semiconductor region SR-1, the distance between the second semiconductor region SR-2 and the second semiconductor region SR-2, and the distance between the first semiconductor region SR-1 and the second semiconductor region SR-2 can be decreased. This arrangement means a high degree of symmetry in layout, and this is advantageous for reducing characteristic variation caused by a manufacturing process.

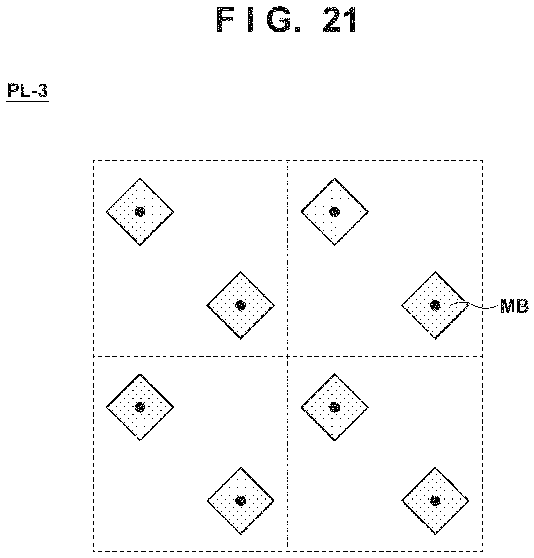

Fig. 21 shows a modification of the second embodiment. This modification has an arrangement obtained by removing, from the arrangement according to the second embodiment shown in Fig. 17, a dummy joint structure DMB arranged at a position where a first electrode plug EP-1 applied with a first voltage VH is not arranged. This arrangement is advantageous for miniaturization of the pixel 101.

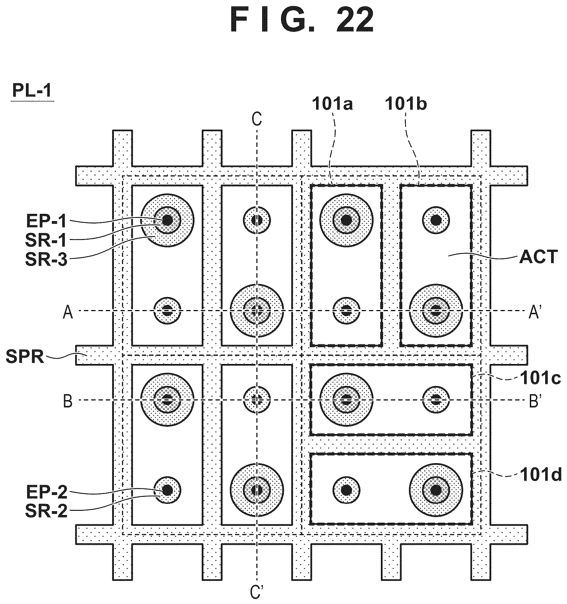

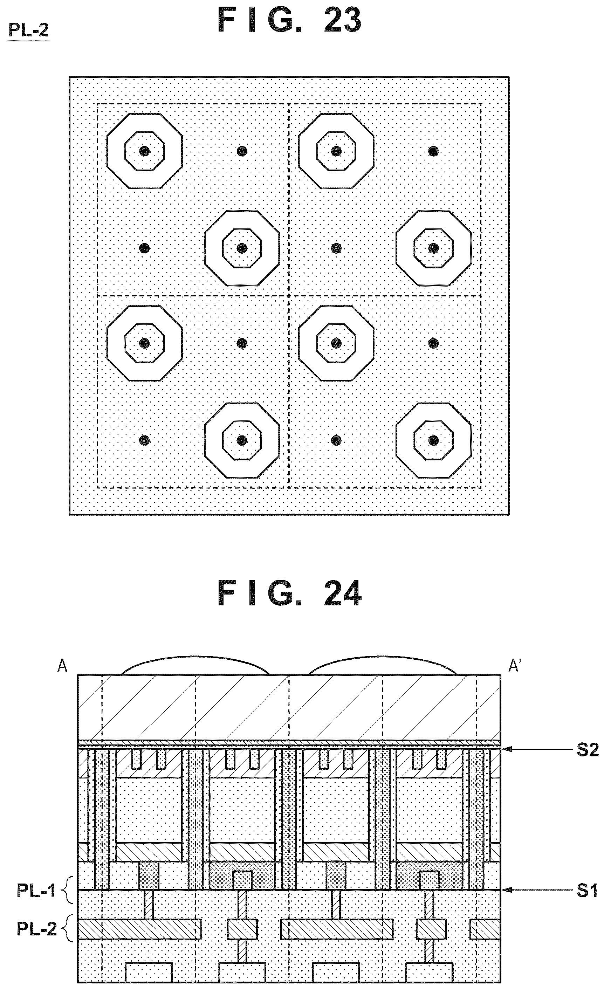

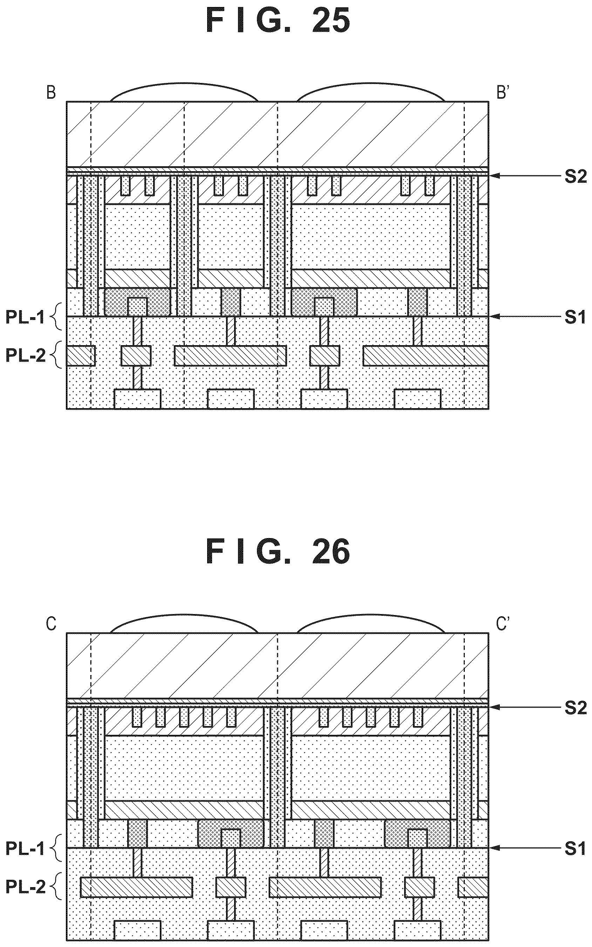

With reference to Figs. 22 to 26, a photoelectric conversion apparatus 100 according to the third embodiment will be described below. Matters not mentioned for the photoelectric conversion apparatus 100 according to the third embodiment can follow the first or second embodiment. Fig. 22 shows the schematic planar view of the photoelectric conversion apparatus 100 in a first plane PL-1. Fig. 23 shows the schematic planar view of the photoelectric conversion apparatus 100 in a second plane PL-2. Fig. 24 is a schematic sectional view of the photoelectric conversion apparatus 100 taken along a line A - A' in Fig. 22. Fig. 25 is a schematic sectional view of the photoelectric conversion apparatus 100 taken along a line B - B' in Fig. 22. Fig. 26 is a schematic sectional view of the photoelectric conversion apparatus 100 taken along a line C - C' in Fig. 22.

In the third embodiment, a direction from a first semiconductor region SR-1 of a first pixel 101a toward a second semiconductor region SR-2 of the first pixel 101a and a direction from the first semiconductor region SR-1 of a second pixel 101b toward the second semiconductor region SR-2 of the second pixel 101b are opposite each other. In addition, a direction from the first semiconductor region SR-1 of a third pixel 101c toward the second semiconductor region SR-2 of the third pixel 101c and a direction from the first semiconductor region SR-1 of a fourth pixel 101d toward the second semiconductor region SR-2 of the fourth pixel 101d are opposite each other. From another viewpoint, in the third embodiment, the longitudinal direction (predetermined direction) of the active region of each of the first pixel 101a and the second pixel 101b is different from the longitudinal direction (predetermined direction) of the active region of each of the third pixel 101c and the fourth pixel 101d by 90°. According to this arrangement, it is possible to detect both of the phase difference between light fluxes passing through two regions arranged in the horizontal direction of the pupil plane, and the phase difference between light fluxes passing through two regions arranged in the vertical direction of the pupil plane.

In the third embodiment as well, the difference among the distance between the first semiconductor region SR-1 and the first semiconductor region SR-1, the distance between the second semiconductor region SR-2 and the second semiconductor region SR-2, and the distance between the first semiconductor region SR-1 and the second semiconductor region SR-2 can be decreased. This arrangement means a high degree of symmetry in layout, and this is advantageous for reducing characteristic variation caused by a manufacturing process.

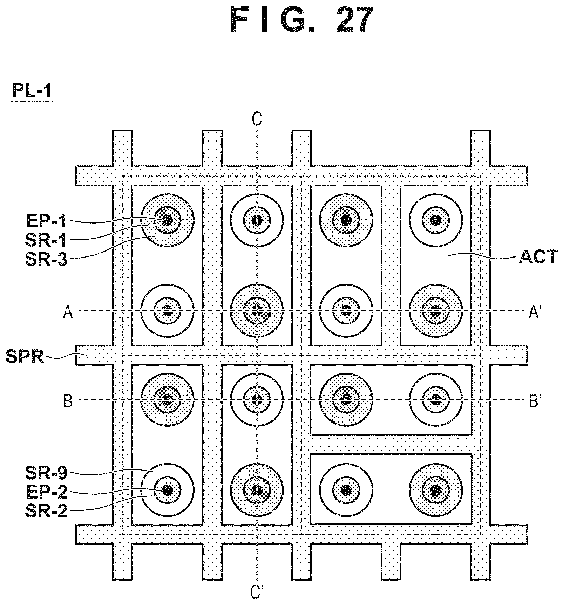

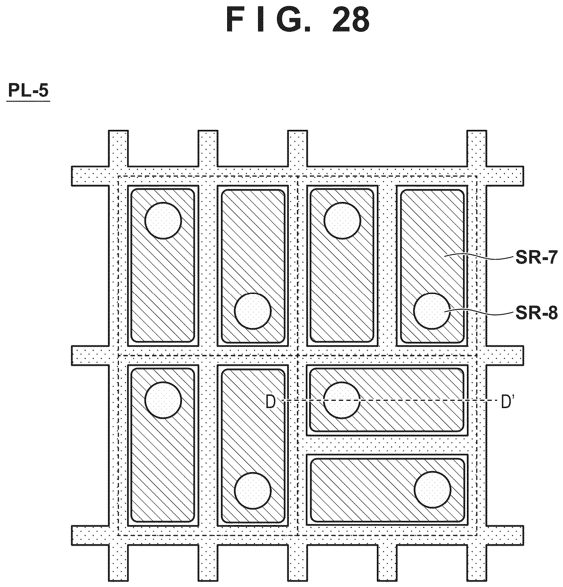

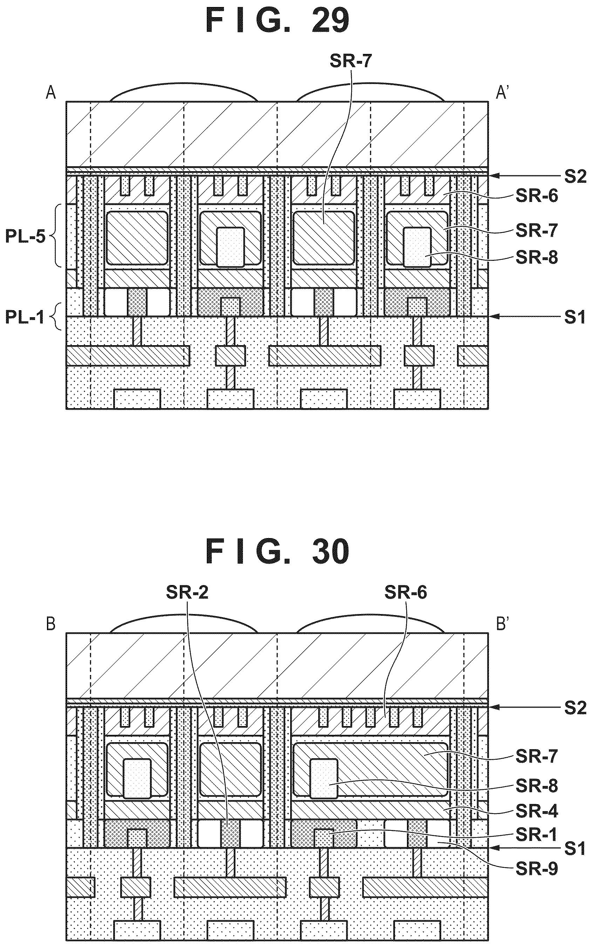

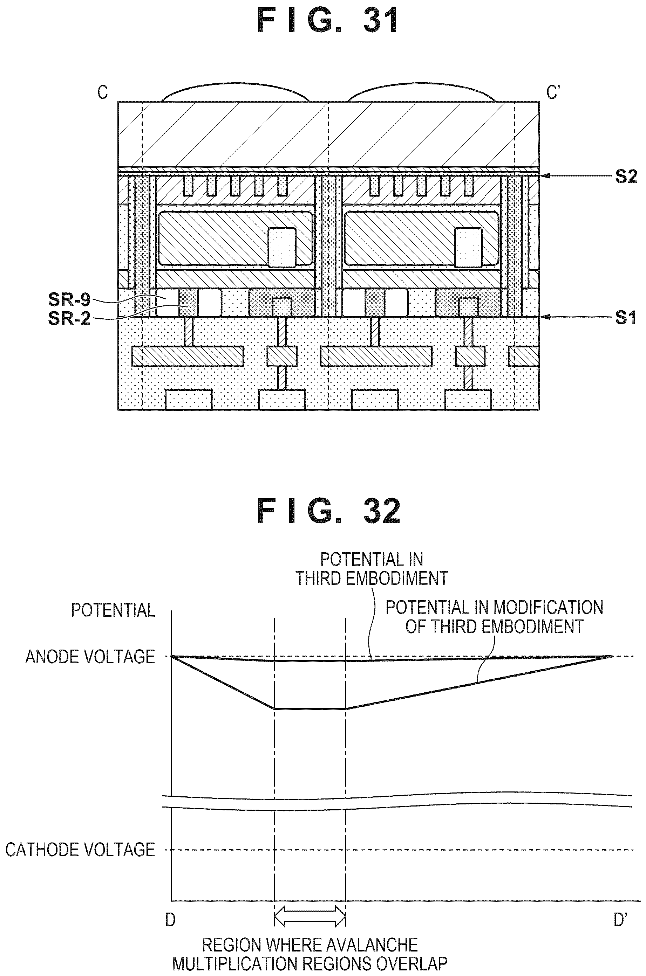

With reference to Figs. 27 to 32, the photoelectric conversion apparatus 100 according to the first modification of the third embodiment will be described below. Matters not mentioned for the photoelectric conversion apparatus 100 according to the first modification of the third embodiment can follow the third embodiment. Fig. 27 shows the schematic planar view of the photoelectric conversion apparatus 100 in the first plane PL-1. Fig. 28 shows the schematic planar view of the photoelectric conversion apparatus 100 in a fifth plane PL-5. Fig. 29 is a schematic sectional view of the photoelectric conversion apparatus 100 taken along a line A - A' in Fig. 27. Fig. 30 is a schematic sectional view of the photoelectric conversion apparatus 100 taken along a line B - B' in Fig. 27. Fig. 31 is a schematic sectional view of the photoelectric conversion apparatus 100 taken along a line C - C' in Fig. 27.

In the first modification, an active region ACT can further include a seventh semiconductor region SR-7 of the first conductivity type arranged between a fourth semiconductor region SR-4 and a sixth semiconductor region SR-6. The active region ACT may further include an eighth semiconductor region SR-8 of the first conductivity type at least partially surrounded by the seventh semiconductor region SR-7. The impurity concentration of the first conductivity type in the eighth semiconductor region SR-8 may be higher than the impurity concentration of the first conductivity type in the seventh semiconductor region SR-7. The eighth semiconductor region SR-8 can be arranged to at least partially overlap the first semiconductor region SR-1 in a planar view (an orthogonal projection onto a first surface S1).

A charge generated by photoelectric conversion in a region between the fourth semiconductor region SR-4 and the sixth semiconductor region SR-6 is detected when it passes through a region (avalanche multiplication region) where the first semiconductor region SR-1 and the fourth semiconductor region SR-4 overlap in the planar view. Therefore, it is advantageous to form a potential gradient so that the charge generated by photoelectric conversion in the region between the fourth semiconductor region SR-4 and the sixth semiconductor region SR-6 is moved (to the avalanche multiplication region). In contrast, if a flat potential region exists, the charge velocity decreases, and responsiveness can be lowered.

Fig. 32 is a potential diagram in a case where the first conductivity type is the n type and the first semiconductor region SR-1 functions as a cathode. By providing the seventh semiconductor region SR-7 of the first conductivity type, a potential gradient can be formed between the end portion of the active region and the avalanche multiplication region. By providing the eighth semiconductor region SR-8, a steeper potential gradient can be formed. Note that even when the eighth semiconductor region SR-8 alone is provided, a potential gradient can be formed between the end portion of the active region and the avalanche multiplication region.

In the first modification, the active region ACT can further include a ninth semiconductor region SR-9 of the second conductivity type arranged to surround the second semiconductor region SR-2. The impurity concentration of the second conductivity type in the ninth semiconductor region SR-9 can be set lower than the impurity concentration of the second conductivity type in the second semiconductor region SR-2. According to this arrangement, the electric field formed between the first semiconductor region SR-1 and the second semiconductor region SR-2 can be relaxed.

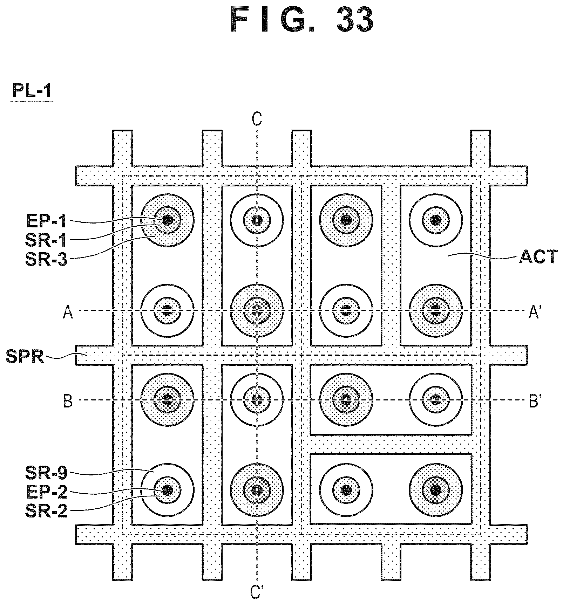

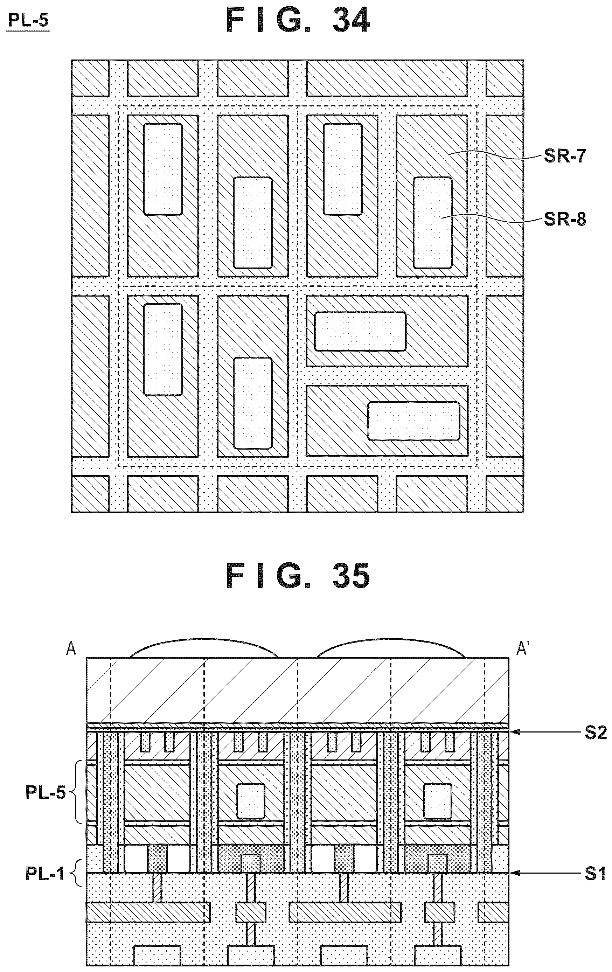

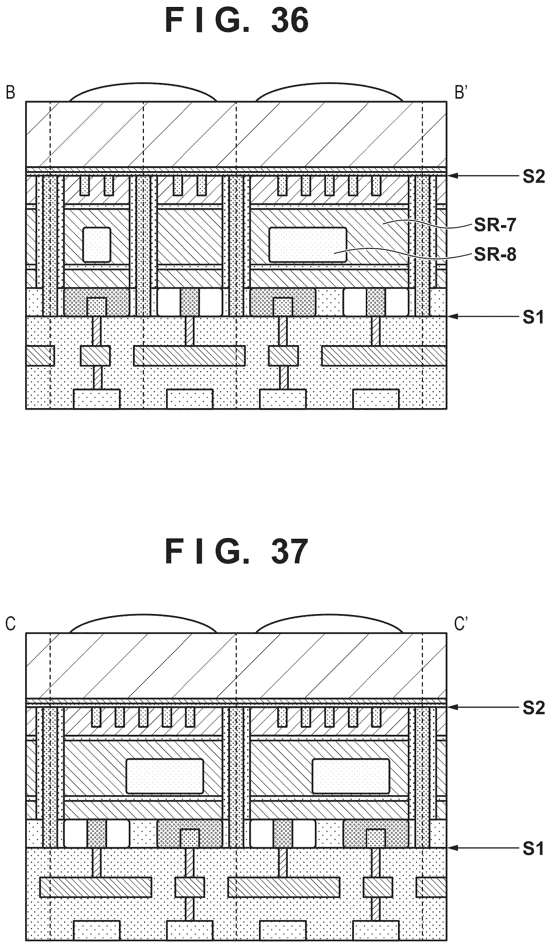

With reference to Figs. 33 to 37, the photoelectric conversion apparatus 100 according to the second modification of the third embodiment will be described below. Matters not mentioned for the photoelectric conversion apparatus 100 according to the second modification of the third embodiment can follow the first modification. Fig. 33 shows the schematic planar view of the photoelectric conversion apparatus 100 in the first plane PL-1. Fig. 34 shows the schematic planar view of the photoelectric conversion apparatus 100 in the fifth plane PL-5. Fig. 35 is a schematic sectional view of the photoelectric conversion apparatus 100 taken along a line A - A' in Fig. 33. Fig. 36 is a schematic sectional view of the photoelectric conversion apparatus 100 taken along a line B - B' in Fig. 33. Fig. 37 is a schematic sectional view of the photoelectric conversion apparatus 100 taken along a line C - C' in Fig. 33. In the second modification, in the active region ACT elongated in a predetermined direction, the eighth semiconductor region SR-8 has an elongated shape in the predetermined direction. This arrangement is advantageous for adjusting a potential gradient between the end portion of the active region and the avalanche multiplication region.

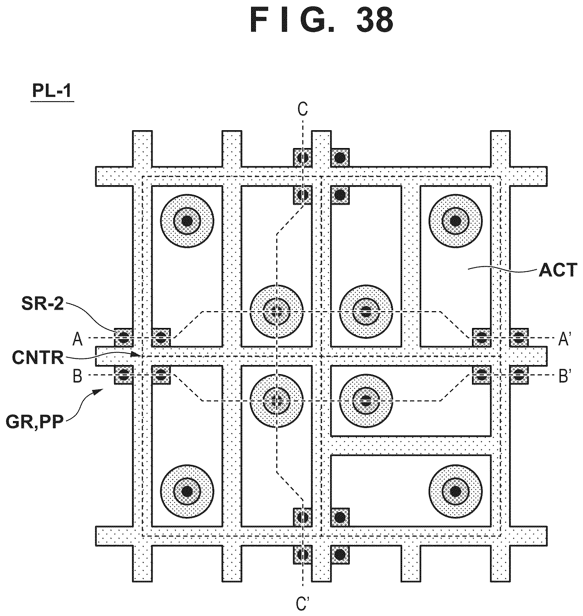

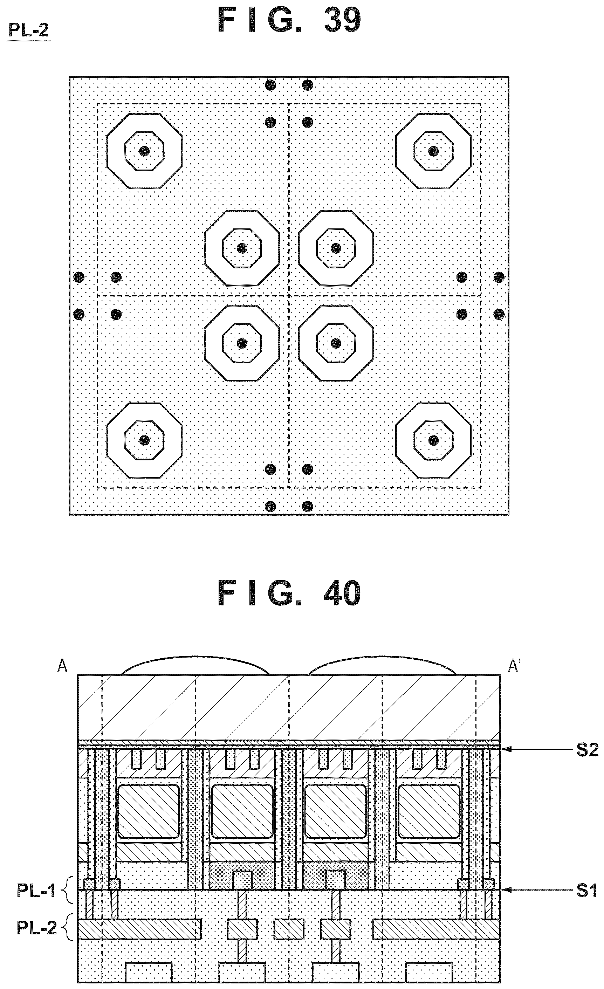

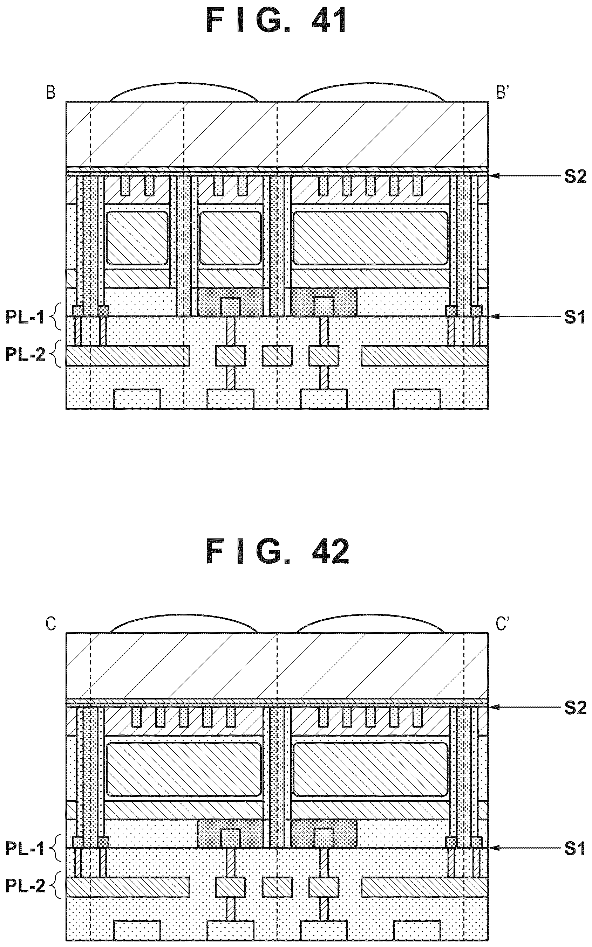

With reference to Figs. 38 to 42, a photoelectric conversion apparatus 100 according to the fourth embodiment will be described below. Matters not mentioned for the photoelectric conversion apparatus 100 according to the fourth embodiment can follow the first to third embodiments. Fig. 38 shows the schematic planar view of the photoelectric conversion apparatus 100 in a first plane PL-1. Fig. 39 shows the schematic planar view of the photoelectric conversion apparatus 100 in a second plane PL-2. Fig. 40 is a schematic sectional view of the photoelectric conversion apparatus 100 taken along a line A - A' in Fig. 38. Fig. 41 is a schematic sectional view of the photoelectric conversion apparatus 100 taken along a line B - B' in Fig. 38. Fig. 42 is a schematic sectional view of the photoelectric conversion apparatus 100 taken along a line C - C' in Fig. 38.

In the fourth embodiment, an active region ACT can include a portion PP where second semiconductor regions SR-2 of four adjacent pixels are arranged close to a center CNTR of an aggregate GR of the four adjacent pixels. According to this arrangement, in each active region ACT, the distance between a first semiconductor region SR-1 and the second semiconductor region SR-2 can be increased, so that an electric field generated between the first semiconductor region SR-1 and the second semiconductor region SR-2 can be relaxed.

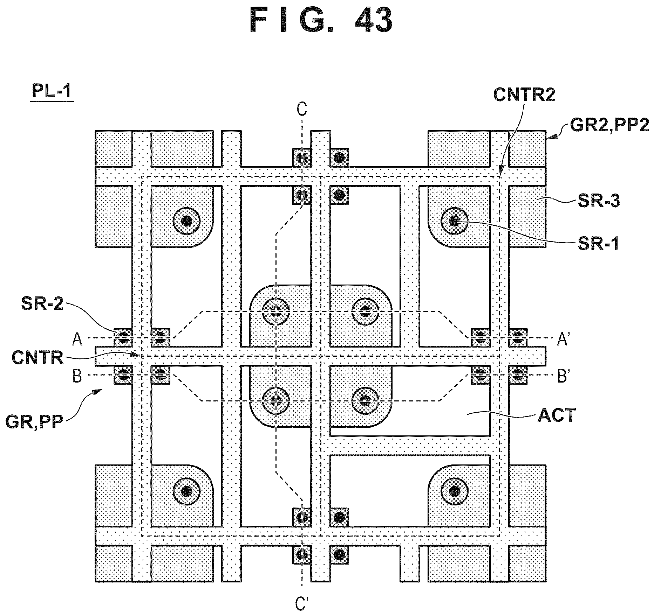

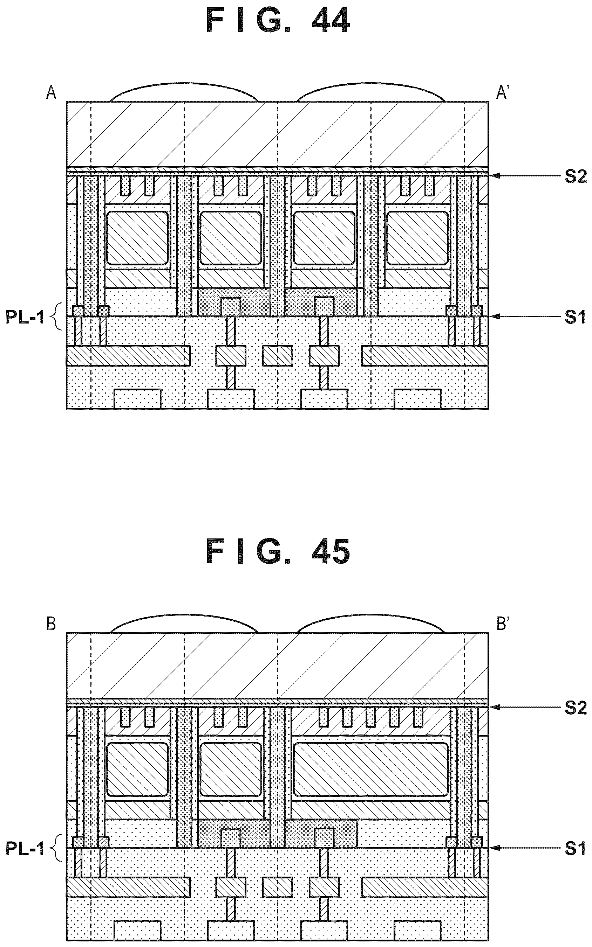

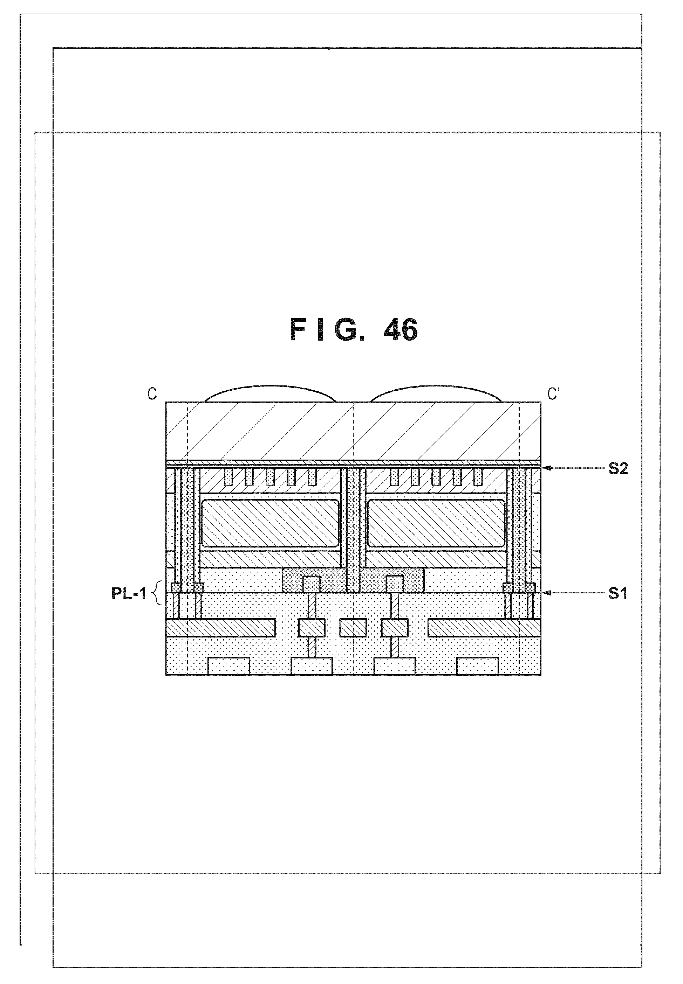

With reference to Figs. 43 to 46, the photoelectric conversion apparatus 100 according to the first modification of the fourth embodiment will be described below. Matters not mentioned for the photoelectric conversion apparatus 100 according to the first modification of the fourth embodiment can follow the fourth embodiment. Fig. 43 shows the schematic planar view of the photoelectric conversion apparatus 100 in the first plane PL-1. Fig. 44 is a schematic sectional view of the photoelectric conversion apparatus 100 taken along a line A - A' in Fig. 43. Fig. 45 is a schematic sectional view of the photoelectric conversion apparatus 100 taken along a line B - B' in Fig. 43. Fig. 46 is a schematic sectional view of the photoelectric conversion apparatus 100 taken along a line C - C' in Fig. 43.

In the first modification of the fourth embodiment, the active region ACT can include a portion PP2 where third semiconductor regions SR-3 of four adjacent pixels are arranged close to a center CNTR2 of an aggregate GR2 of the four adjacent pixels. According to this arrangement, the spacing between the third semiconductor regions SR-3 adjacent to each other can be increased. Accordingly, even if the pixel pitch is small, a mask for forming the third semiconductor region SR-3 can be easily formed.

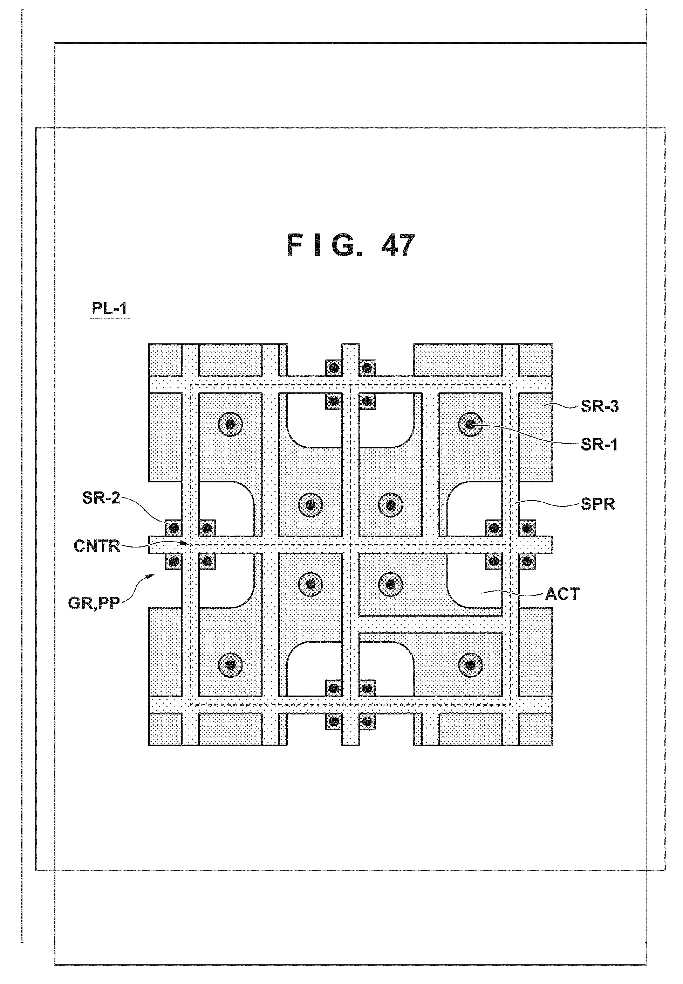

With reference to Fig. 47, the photoelectric conversion apparatus 100 according to the second modification of the fourth embodiment will be described below. Matters not mentioned for the photoelectric conversion apparatus 100 according to the second modification of the fourth embodiment can follow the first modification of the fourth embodiment. Fig. 47 is a view corresponding to Fig. 43 which shows the first modification of the fourth embodiment. In the second modification of the fourth embodiment, as in the first modification of the fourth embodiment, the active region ACT can include the portion PP where the second semiconductor regions SR-2 of four adjacent pixels are arranged close to the center CNTR of the aggregate GR of the four adjacent pixels. Furthermore, in the second modification of the fourth embodiment, the third semiconductor regions SR-3 of the four adjacent pixels are arranged to surround the aggregate GR. In one active region ACT, the third semiconductor region SR-3 surrounds the second semiconductor region SR-2 over a range of 90°. According to this arrangement, a mask for forming the third semiconductor region SR-3 includes a single continuous region as a region corresponding to the third semiconductor region SR-3. Hence, the mask can be easily formed.

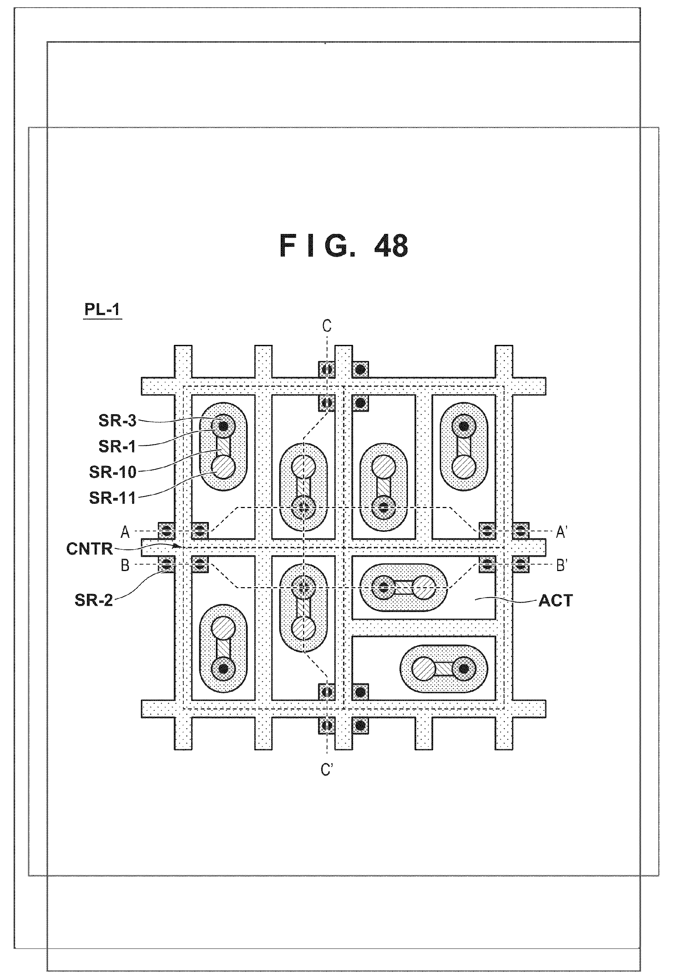

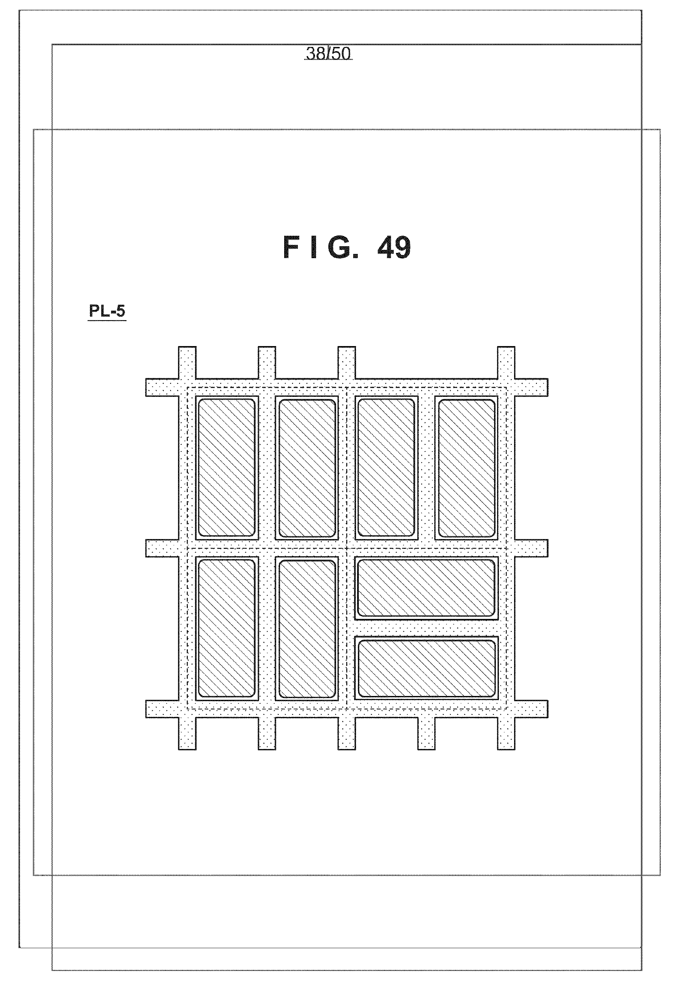

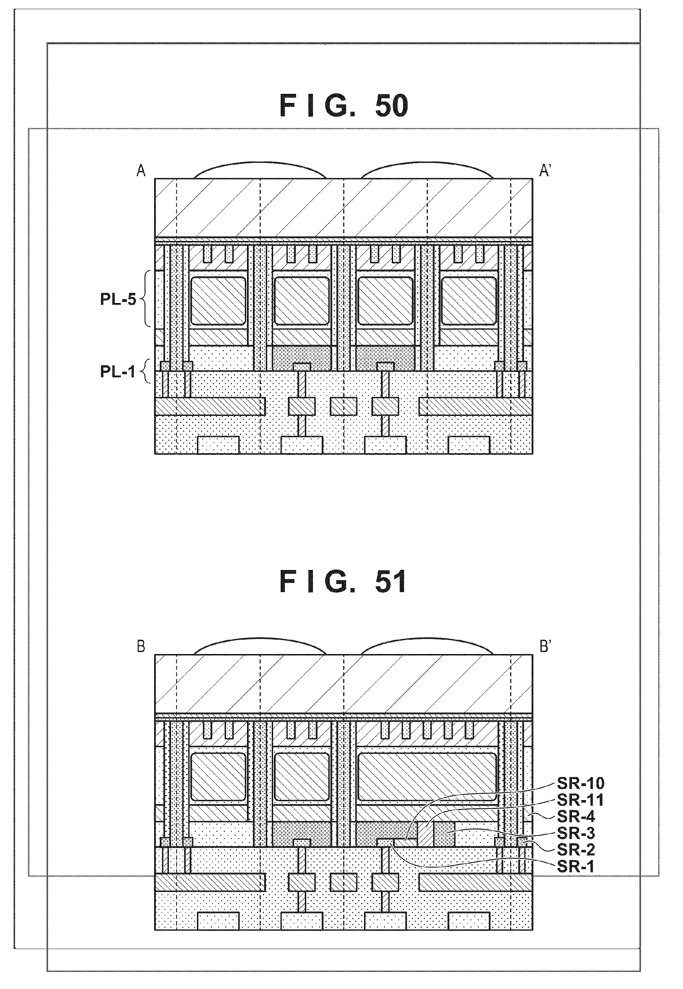

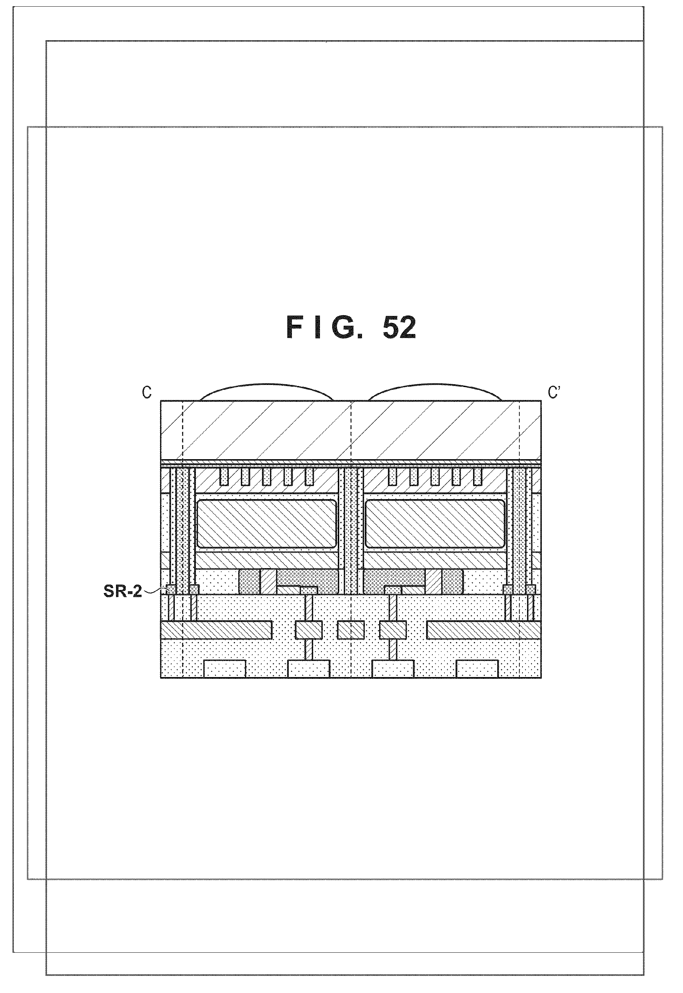

With reference to Figs. 48 to 52, a photoelectric conversion apparatus 100 according to the fifth embodiment will be described below. Matters not mentioned for the photoelectric conversion apparatus 100 according to the fifth embodiment can follow the first to fourth embodiments. Fig. 48 shows the schematic planar view of the photoelectric conversion apparatus 100 in a first plane PL-1. Fig. 49 shows the schematic planar view of the photoelectric conversion apparatus 100 in a fifth plane PL-5. Fig. 50 is a schematic sectional view of the photoelectric conversion apparatus 100 taken along a line A - A' in Fig. 48. Fig. 51 is a schematic sectional view of the photoelectric conversion apparatus 100 taken along a line B - B' in Fig. 48. Fig. 52 is a schematic sectional view of the photoelectric conversion apparatus 100 taken along a line C - C' in Fig. 48.

In the fifth embodiment, an active region ACT can further include a tenth semiconductor region SR-10 of the first conductivity type, and an eleventh semiconductor region SR-11 of the first conductivity type. The tenth semiconductor region SR-10 can be arranged to electrically connect a first semiconductor region SR-1 and the eleventh semiconductor region SR-11. A third semiconductor region SR-3 can be arranged to surround the first semiconductor region SR-1, the tenth semiconductor region SR-10, and the eleventh semiconductor region SR-11. The distance between the centroid of the eleventh semiconductor region SR-11 and the centroid of the active region ACT may be smaller than the distance between the centroid of the first semiconductor region SR-1 and the centroid of the active region ACT. The impurity concentration of the first conductivity type in each of the tenth semiconductor region SR-10 and the eleventh semiconductor region SR-11 may be lower than the impurity concentration of the first conductivity type in the first semiconductor region SR-1. For example, the impurity concentration of the first conductivity type in each of the tenth semiconductor region SR-10 and the eleventh semiconductor region SR-11 can be 1/10 or less of the impurity concentration of the first conductivity type in the first semiconductor region SR-1. In other words, the impurity concentrations in the tenth semiconductor region SR-10 and the eleventh semiconductor region SR-11 can be adjusted to prevent formation of an avalanche multiplication region.

A first voltage VH is applied to the eleventh semiconductor region SR-11 via the first semiconductor region SR-1 and the tenth semiconductor region SR-10, and an avalanche multiplication region can be formed between the eleventh semiconductor region SR-11 and the tenth semiconductor region SR-10. According to the fifth embodiment, it is possible to arrange the eleventh semiconductor region SR-11 at the center of the pixel or active region or at a position close to the center, while increasing the distance between the first semiconductor region SR-1 and a second semiconductor region SR-2. With this arrangement, charges can be collected in the avalanche multiplication region regardless of the position where the charges are generated by photoelectric conversion. Accordingly, it is possible to reduce the time required for charge collection, and decrease the variation in the time (the characteristic generally called timing jitter). This characteristic is particularly important when the photoelectric conversion apparatus 100 is applied to a distance measurement application or the like.

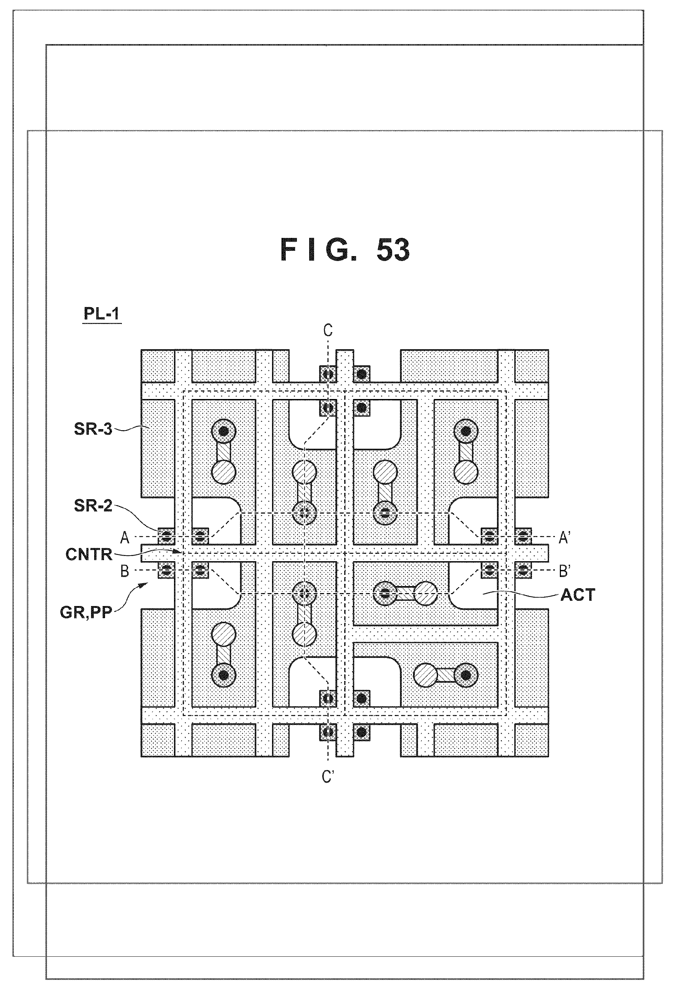

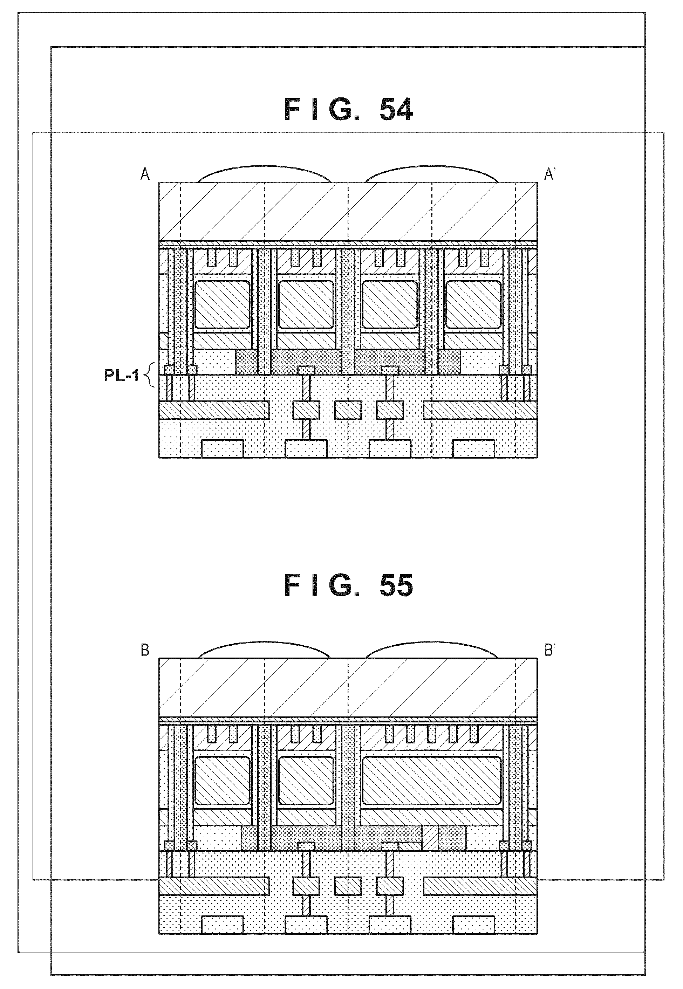

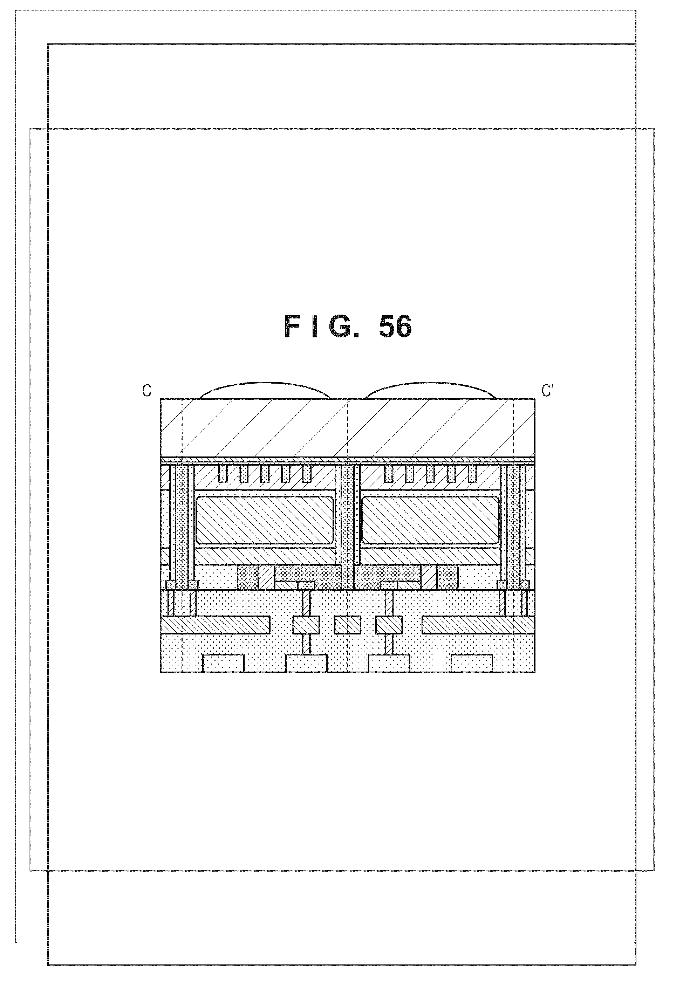

With reference to Figs. 53 to 56, the photoelectric conversion apparatus 100 according to a modification of the fifth embodiment will be described below. Matters not mentioned for the photoelectric conversion apparatus 100 according to the modification of the fifth embodiment can follow the fifth embodiment. Fig. 53 shows the schematic planar view of the photoelectric conversion apparatus 100 in the first plane PL-1. Fig. 54 is a schematic sectional view of the photoelectric conversion apparatus 100 taken along a line A - A' in Fig. 53. Fig. 55 is a schematic sectional view of the photoelectric conversion apparatus 100 taken along a line B - B' in Fig. 53. Fig. 56 is a schematic sectional view of the photoelectric conversion apparatus 100 taken along a line C - C' in Fig. 53.

In the modification of the fifth embodiment, the active region ACT can include a portion PP where second semiconductor regions SR-2 of four adjacent pixels are arranged close to a center CNTR of an aggregate GR of the four adjacent pixels. Furthermore, in the modification of the fifth embodiment, the third semiconductor regions SR-3 of the four adjacent pixels are arranged to surround the aggregate GR. In one active region ACT, the third semiconductor region SR-3 surrounds the second semiconductor region SR-2 over a range of 90°. According to this arrangement, a mask for forming the third semiconductor region SR-3 includes a single continuous region as a region corresponding to the third semiconductor region SR-3. Hence, the mask can be easily formed.

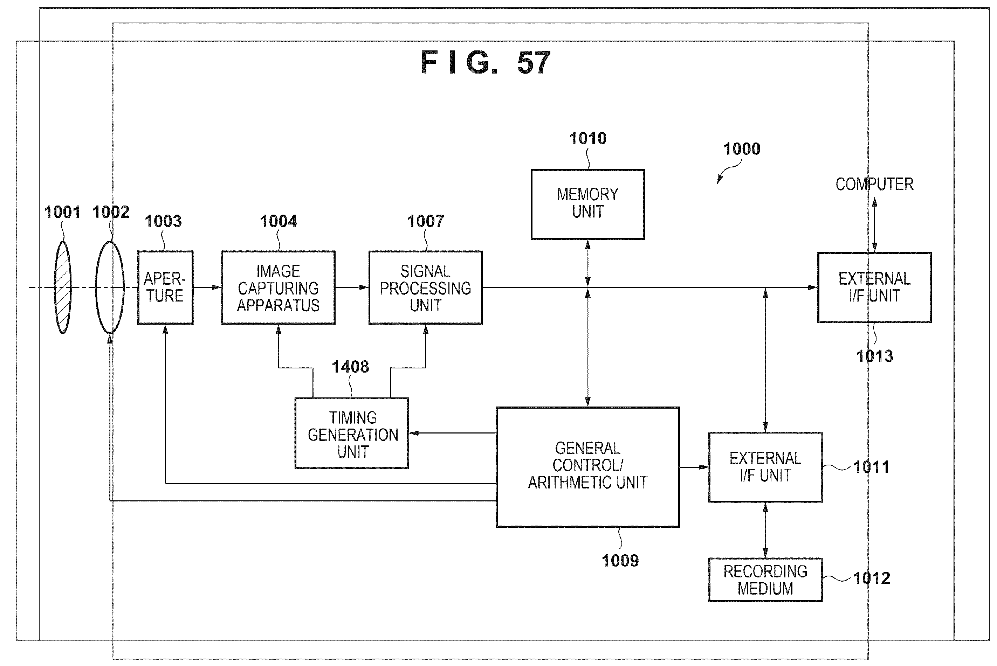

With reference to Fig. 57, a photoelectric conversion system according to the first application example will be described below. Fig. 57 is a block diagram showing the schematic configuration of a photoelectric conversion system according to the first application example.

The above-described photoelectric conversion apparatus 100 is applicable to various kinds of photoelectric conversion systems. Examples of photoelectric conversion systems to which the photoelectric conversion apparatus is applicable are a digital still camera, a digital camcorder, a monitoring camera, a copying machine, a facsimile apparatus, a mobile phone, an in-vehicle camera, and an observation satellite. A camera module including an optical system such as a lens and an image capturing apparatus is also included in the photoelectric conversion systems. Fig. 57 exemplarily shows the block diagram of a digital still camera as an example of these.

A photoelectric conversion system 1000 exemplarily shown in Fig. 57 includes an image capturing apparatus 1004 as an example of the photoelectric conversion apparatus. The photoelectric conversion system 1000 also includes a lens 1002 that forms an optical image of an object on the image capturing apparatus 1004, an aperture 1003 configured to change the amount of light passing through the lens 1002, and a barrier 1001 configured to protect the lens 1002. The lens 1002 and the aperture 1003 form an optical system (optical apparatus) that condenses light onto the image capturing apparatus 1004. The image capturing apparatus 1004 is the photoelectric conversion apparatus 100 (image capturing apparatus) according to one of the above-described embodiments, and converts the optical image formed by the lens 1002 into an electrical signal.

The photoelectric conversion system 1000 also includes a signal processing unit 1007 that is an image generation unit configured to generate an image by processing an output signal output from the image capturing apparatus 1004. The signal processing unit 1007 functions as a processing apparatus that performs an operation of performing various kinds of correction and compression as needed, thereby outputting image data. The signal processing unit 1007 may be formed on a semiconductor substrate on which the image capturing apparatus 1004 is provided or may be formed on a semiconductor substrate different from the image capturing apparatus 1004. In addition, the image capturing apparatus 1004 and the signal processing unit 1007 may be formed on the same semiconductor substrate.

The photoelectric conversion system 1000 further includes a memory unit 1010 configured to temporarily store image data, and an external interface unit (external I/F unit) 1013 configured to communicate with an external computer or the like. Furthermore, the photoelectric conversion system 1000 includes a recording medium 1012 such as a semiconductor memory configured to record or read out image capturing data, and a recording medium control I/F unit 1011 configured to perform record or readout for the recording medium 1012. The recording medium control I/F unit 1011 and the recording medium 1012 can form a part of a recording apparatus. Note that the recording medium 1012 may be incorporated in the photoelectric conversion system 1000 or may be detachable.

Furthermore, the photoelectric conversion system 1000 includes a general control/arithmetic unit 1009 that controls various kinds of operations and the entire digital still camera, and a timing generation unit 1408 that outputs various kinds of timing signals to the image capturing apparatus 1004 and the signal processing unit 1007. The general control/arithmetic unit 1009 and the timing generation unit 1408 can form a part of a control apparatus configured to control an operation of the photoelectric conversion system 1000. In this example, the timing signal and the like may be input from the outside, and the photoelectric conversion system 1000 need only include at least the image capturing apparatus 1004, and the signal processing unit 1007 that processes an output signal output from the image capturing apparatus 1004.

The image capturing apparatus 1004 outputs an image capturing signal to the signal processing unit 1007. The signal processing unit 1007 executes predetermined signal processing for the image capturing signal output from the image capturing apparatus 1004, and outputs image data. The signal processing unit 1007 generates an image using the image capturing signal. Although not shown in Fig. 57, a display apparatus such as a display for displaying the generated image may be arranged in the photoelectric conversion system 1000. As described above, according to this application example, it is possible to implement the photoelectric conversion system 1000 to which the photoelectric conversion apparatus 100 (image capturing apparatus) according to one of the above-described embodiments is applied.

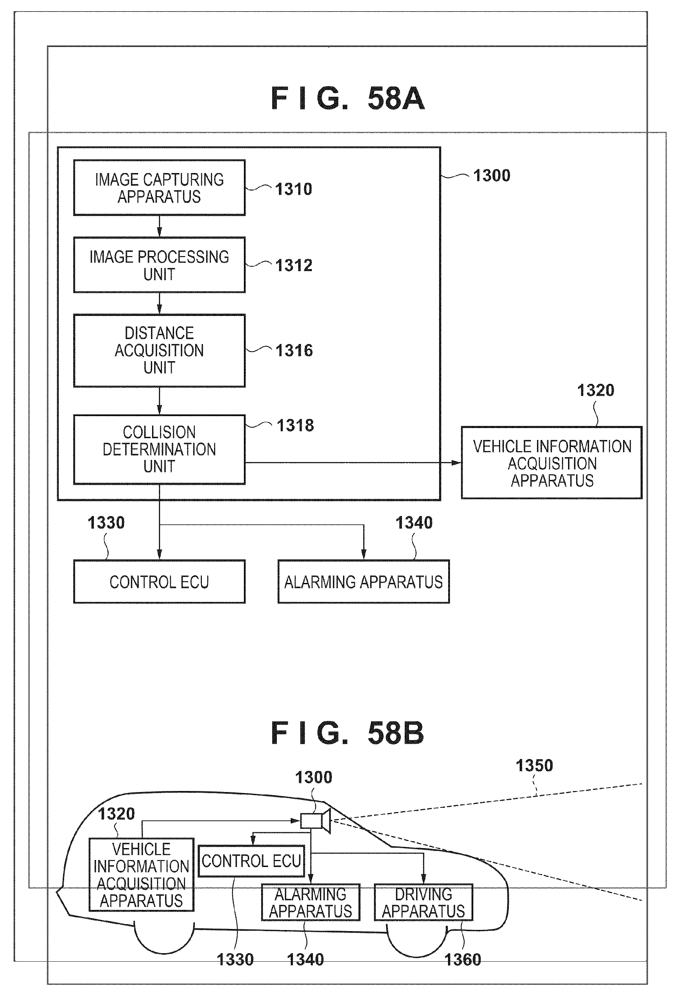

A photoelectric conversion system 1300 and a moving body 1301 according to the second application example will be described with reference to Figs. 58A and 58B. Figs. 58A and 58B are views showing the arrangement of the photoelectric conversion system 1300 and the moving body 1301 according to the second application example.

Fig. 58A shows an example of a photoelectric conversion system concerning an in-vehicle camera. The photoelectric conversion system 1300 includes an image capturing apparatus 1310. The image capturing apparatus 1310 is the photoelectric conversion apparatus 100 (image capturing apparatus) described in one of the above-described embodiments. The photoelectric conversion system 1300 includes an image processing unit 1312 that performs image processing for a plurality of image data acquired by the image capturing apparatus 1310. The photoelectric conversion system 1300 also includes a distance acquisition unit 1316 that calculates the distance to a target object, and a collision determination unit 1318 that determines, based on the calculated distance, whether there is the possibility of collision. Here, the distance acquisition unit 1316 may acquire distance information up to a target object by using Time of Flight (ToF) method, or may acquire distance information by using parallax information or the like. That is, the distance information is information concerning a parallax, a defocus amount, a distance to a target object, and the like. The collision determination unit 1318 may determine the possibility of collision using one of the pieces of distance information. The distance acquisition unit 1316 may be implemented by exclusively designed hardware, or may be implemented by a software module. The distance acquisition unit 1316 may be implemented by a Field Programmable Gate Array (FPGA), Application Specific Integrated Circuit (ASIC), or the like. Alternatively, the distance acquisition unit 1316 may be implemented by a combination of these.

The photoelectric conversion system 1300 is connected to a vehicle information acquisition apparatus 1320, and can acquire vehicle information such as a vehicle speed, a yaw rate, and a steering angle. The photoelectric conversion system 1300 is also connected to an ECU 1330 that is a control apparatus configured to output a control signal for generating a braking force to the vehicle based on the determination result of the collision determination unit 1318. Furthermore, the photoelectric conversion system 1300 is connected to an alarm apparatus 1340 that generates an alarm to the driver based on the determination result of the collision determination unit 1318. For example, if the possibility of collision is high as the determination result of the collision determination unit 1318, the ECU 1330 controls a driving apparatus (machine apparatus) 1360 to perform braking, releasing the accelerator pedal, or suppressing the engine output, thereby controlling the vehicle for avoiding collision and reducing damage. The alarm apparatus 1340 sounds an alarm, displays alarm information on the screen of a car navigation system or the like, or applies a vibration to the seat belt or a steering wheel, thereby issuing an alarm to the user.

In this application example, the periphery of the vehicle (moving body 1301), for example, the front or rear side is captured by the photoelectric conversion system 1300. Fig. 58B shows the photoelectric conversion system when capturing the front side (image capturing range 1350) of the vehicle. The vehicle information acquisition apparatus 1320 sends an instruction to the photoelectric conversion system 1300 or the image capturing apparatus 1310. With this configuration, it is possible to further improve the accuracy of distance measurement.

An example in which control is executed so as not to collide with another vehicle has been explained above. The photoelectric conversion system 1300 can also be applied to control of performing automated driving following another vehicle or control of performing automated driving without deviating from a lane. Furthermore, the photoelectric conversion system 1300 can be applied not only to a vehicle such as an automobile but also to, for example, a moving body (moving apparatus) such as a ship, an airplane, or an industrial robot. The moving body includes one or both of a driving force generation unit that generates a driving force mainly used for moving the moving body and a rotating body mainly used for moving the moving body. The driving force generation unit can be an engine, a motor, or the like. The rotating body can be a tire, a wheel, a ship screw, a propeller of a moving body, or the like. In addition, the photoelectric conversion system can be applied not only to a moving body but also to equipment that broadly uses object recognition, such as an intelligent transport system (ITS).

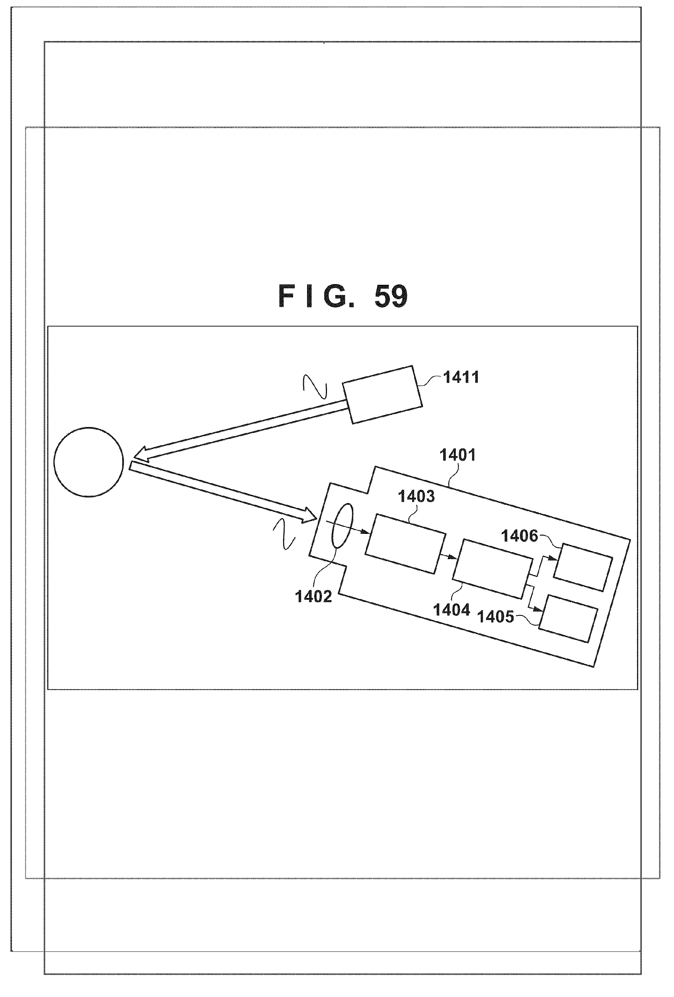

A photoelectric conversion system according to the third application example will be described with reference to Fig. 59. Fig. 59 is a block diagram showing an example of the arrangement of a distance image sensor 1401 as the photoelectric conversion system according to this embodiment.

As shown in Fig. 59, the distance image sensor 1401 includes an optical system 1402, a photoelectric conversion apparatus 1403, an image processing circuit 1404, a monitor 1405, and a memory 1406. Then, the distance image sensor 1401 can receive light (modulated light or pulsed light) projected from a light source apparatus 1411 toward an object and reflected by the surface of the object, thereby acquiring a distance image corresponding to the distance to the object.

The optical system 1402 is formed by including one or a plurality of lenses, and guides image light (incident light) from the object to the photoelectric conversion apparatus 1403 and forms an image on the light-receiving surface (sensor portion) of the photoelectric conversion apparatus 1403.

As the photoelectric conversion apparatus 1403, the photoelectric conversion apparatus 100 of each of the above-described embodiments is applied, and a distance signal indicating a distance obtained from a light reception signal output from the photoelectric conversion apparatus 1403 is supplied to the image processing circuit 1404.

The image processing circuit 1404 performs image processing of creating a distance image based on the distance signal supplied from the photoelectric conversion apparatus 1403. Then, the distance image (image data) obtained by the image processing is supplied to and displayed on the monitor 1405, and supplied to and stored (recorded) in the memory 1406.

The distance image sensor 1401 having such arrangement can acquire, for example, a more correct distance image along with improvement in characteristic of pixels by applying the above-described photoelectric conversion apparatus 100.

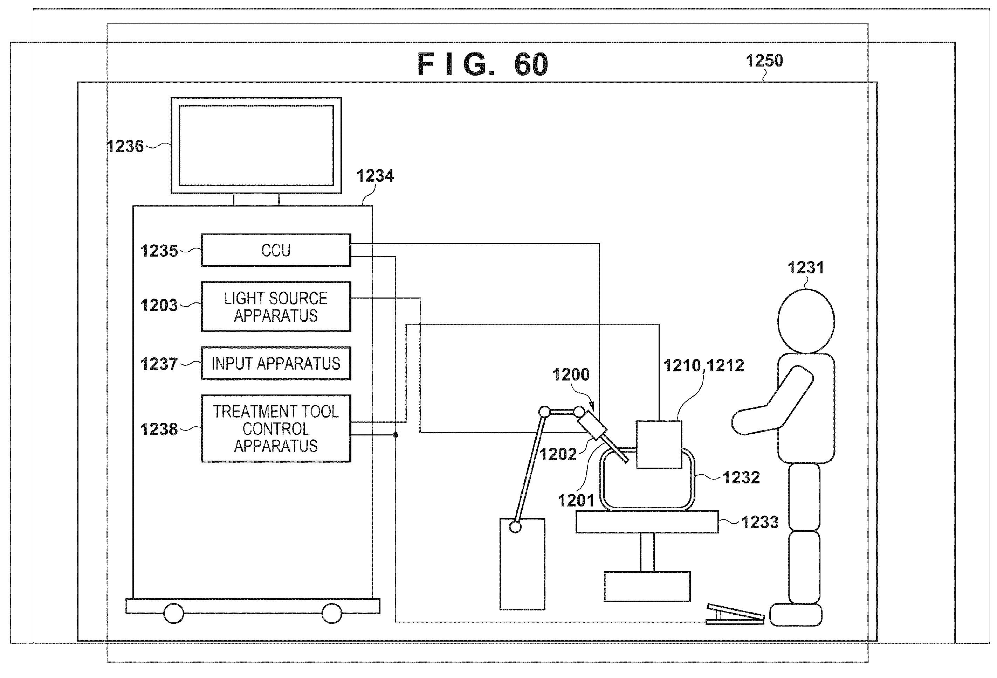

A photoelectric conversion system according to the fourth application example will be described with reference to Fig. 60. Fig. 60 is a view showing an example of the schematic arrangement of an endoscopic surgery system 1250 as the photoelectric conversion system according to fourth application example.

Fig. 60 shows a state in which an operator (doctor) 1231 operates on a patient 1232 on a patient bed 1233 using the endoscopic surgery system 1250. As shown in Fig. 60, the endoscopic surgery system 1250 is formed from an endoscope 1200, a surgical tool 1210, and a cart 1234 on which various apparatuses for endoscopic surgery are mounted.

The endoscope 1200 includes a lens barrel 1201 including a region of a predetermined length from the distal end, which is inserted into the body cavity of the patient 1232, and a camera head 1202 connected to the proximal end of the lens barrel 1201. In the example shown in Fig. 60, the endoscope 1200 formed as a so-called hard mirror including the hard lens barrel 1201 is shown but the endoscope 1200 may be formed as a so-called soft mirror including a soft lens barrel.

An opening in which an objective lens is fitted is provided at the distal end of the lens barrel 1201. A light source apparatus 1203 is connected to the endoscope 1200, and light generated by the light source apparatus 1203 is guided to the distal end of the lens barrel by a light guide extended inside the lens barrel 1201, and is emitted to an observation target in the body cavity of the patient 1232 via the objective lens. Note that the endoscope 1200 may be a forward-viewing endoscope or may be a forward-oblique viewing endoscope or side-viewing endoscope.

An optical system and a photoelectric conversion apparatus are provided in the camera head 1202, and reflected light (observation light) from the observation target is condensed by the optical system onto the photoelectric conversion apparatus. The observation light is photoelectrically converted by the photoelectric conversion apparatus to generate an electrical signal corresponding to the observation light, that is, an image signal corresponding to an observation image. As the photoelectric conversion apparatus, the photoelectric conversion apparatus 100 (image capturing apparatus) described in each of the above-described embodiments can be used. The image signal is transmitted as RAW data to a Camera Control Unit (CCU) 1235.

The CCU 1235 is formed by a Central Processing Unit (CPU), a Graphics Processing Unit (GPU), and the like, and comprehensively controls the operations of the endoscope 1200 and a display apparatus 1236. Furthermore, the CCU 1235 receives an image signal from the camera head 1202, and performs, for the image signal, various kinds of image processes such as development processing (demosaic processing) for displaying an image based on the image signal.

Under the control of the CCU 1235, the display apparatus 1236 displays the image based on the image signal having undergone the image processing by the CCU 1235.

The light source apparatus 1203 is formed from a light source such as a Light Emitting Diode (LED), and supplies, to the endoscope 1200, irradiation light at the time of imaging an operation site or the like.

An input apparatus 1237 is an input interface to the endoscopic surgery system 1250. The user can input various kinds of information or instructions to the endoscopic surgery system 1250 via the input apparatus 1237.

A treatment tool control apparatus 1238 controls driving of an energy treatment tool 1212 for ablation or incision of the tissue, sealing of a blood vessel, or the like.

The light source apparatus 1203 that supplies, to the endoscope 1200, irradiation light at the time of imaging an operation site can be formed from, for example, a white light source formed by an LED, a laser light source, or a combination thereof. If the white light source is formed by a combination of RGB laser light sources, it is possible to accurately control the output intensity and output timing of each color (each wavelength), and thus the light source apparatus 1203 can adjust the white balance of a captured image. In this case, the observation target is time-divisionally irradiated with laser beams from the RGB laser light sources, respectively, and driving of the image sensor of the camera head 1202 is controlled in synchronism with the irradiation timings, thereby making it possible to time-divisionally capture images respectively corresponding to R, G, and B. In this method, it is possible to obtain a color image without providing color filters in the image sensor.

Driving of the light source apparatus 1203 may be controlled to change the intensity of light to be output at predetermined time intervals. It is possible to time-divisionally acquire images by controlling driving of the image sensor of the camera head 1202 in synchronism with the timing of changing the intensity of the light, and combine the images, thereby generating an image of a high dynamic range without so-called shadow detail loss or highlight detail loss.

The light source apparatus 1203 may be configured to supply light in a predetermined wavelength band corresponding to special light observation. In special light observation, for example, the wavelength dependency of light absorption in the body tissue is used. More specifically, by performing irradiation with light in a narrow band, as compared with irradiation light (that is, white light) at the time of normal observation, predetermined tissue such as a blood vessel in the mucous membrane surface layer is captured with high contrast. Alternatively, in special light observation, fluorescence observation for obtaining an image by using fluorescence generated by performing radiation with excitation light may be performed. In fluorescence observation, it is possible to, for example, irradiate body tissue with excitation light and observe fluorescence from the body tissue, or locally inject a reagent such as indocyanine green (ICG) to body tissue while irradiating the body tissue with excitation light corresponding to the fluorescence wavelength of the reagent, thereby obtaining a fluorescence image. The light source apparatus 1203 can be configured to supply narrow band light and/or excitation light corresponding to such special light observation.

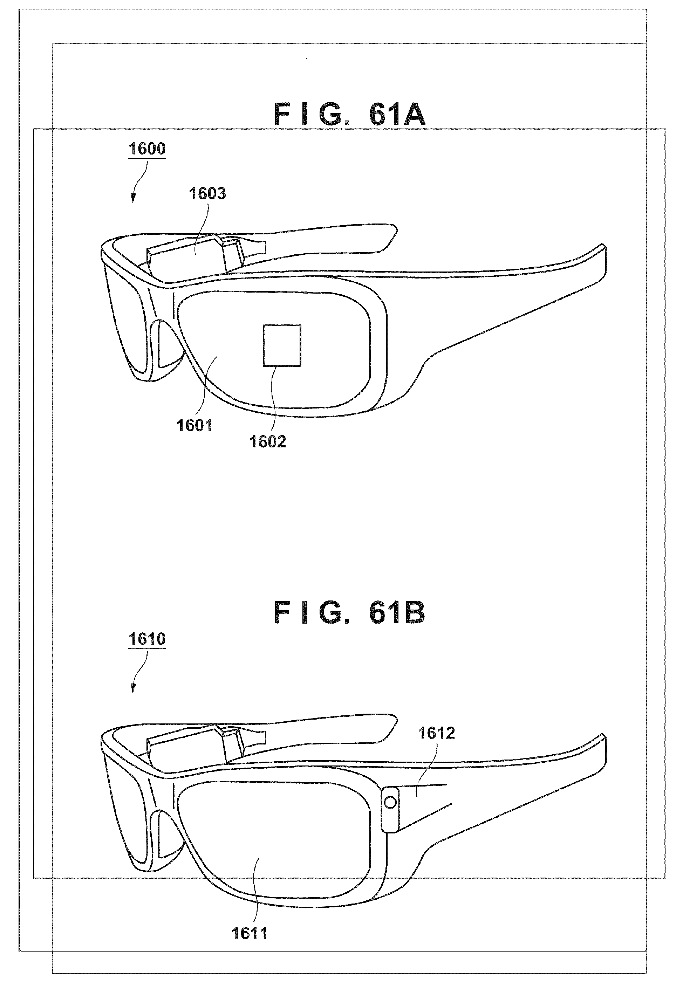

A photoelectric conversion system according to the fifth application example will be described with reference to Figs. 61A and 61B. Fig. 61A describes glasses 1600 (smartglasses) as the photoelectric conversion system according to the fifth application example. The glasses 1600 include a photoelectric conversion apparatus 1602. The photoelectric conversion apparatus 1602 is the photoelectric conversion apparatus 100 (image capturing apparatus) described in each of the above embodiments. A display apparatus including the light emitting apparatus such as an OLED or LED may be provided on the back surface side of a lens 1601. One or a plurality of photoelectric conversion apparatuses 1602 may be provided. Alternatively, a plurality of kinds of photoelectric conversion apparatuses may be used in combination. The arrangement position of the photoelectric conversion apparatus 1602 is not limited to that shown in Fig. 61A.

The glasses 1600 further include a control apparatus 1603. The control apparatus 1603 functions as a power supply that supplies electric power to the photoelectric conversion apparatus 1602 and the above-described display apparatus. In addition, the control apparatus 1603 controls the operations of the photoelectric conversion apparatus 1602 and the display apparatus. An optical system configured to condense light onto the photoelectric conversion apparatus 1602 is formed on the lens 1601.

Fig. 61B describes glasses 1610 (smartglasses) according to an application example. The glasses 1610 include a control apparatus 1612, and a photoelectric conversion apparatus corresponding to the photoelectric conversion apparatus 1602 and a display apparatus are mounted on the control apparatus 1612. The photoelectric conversion apparatus in the control apparatus 1612 and an optical system configured to project light emitted from the display apparatus are formed in a lens 1611, and an image is projected onto the lens 1611. The control apparatus 1612 functions as a power supply that supplies electric power to the photoelectric conversion apparatus and the display apparatus, and controls the operations of the photoelectric conversion apparatus and the display apparatus. The control apparatus may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a plan view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The display apparatus according to this application example can include a photoelectric conversion apparatus including a light receiving element, and control a displayed image of the display apparatus based on the line-of-sight information of the user from the photoelectric conversion apparatus.

More specifically, the display apparatus decides a first visual field region at which the user is gazing and a second visual field region other than the first visual field region based on the line-of-sight information. The first visual field region and the second visual field region may be decided by the control apparatus of the display apparatus, or those decided by an external control apparatus may be received. In the display region of the display apparatus, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority may be decided from the first display region and the second display region based on line-of-sight information. The first visual field region and the second visual field region may be decided by the control apparatus of the display apparatus, or those decided by an external control apparatus may be received. The resolution of the region of higher priority may be controlled to be higher than the resolution of the region other than the region of higher priority. That is, the resolution of the region of relatively low priority may be low.

Note that Al may be used to decide the first visual field region or the region of higher priority. The Al may be a model configured to estimate the angle of the line of sight and the distance to a target object ahead of the line of sight from the image of the eyeball using the image of the eyeball and the direction of actual viewing of the eyeball in the image as supervised data. The Al program may be held by the display apparatus, the photoelectric conversion apparatus, or an external apparatus. If the external apparatus holds the Al program, it is transmitted to the display apparatus via communication.

When performing display control based on line-of-sight detection, smartglasses further including a photoelectric conversion apparatus configured to capture the image of the outside can preferably be applied. The smartglasses can display the captured outside image information in real time.

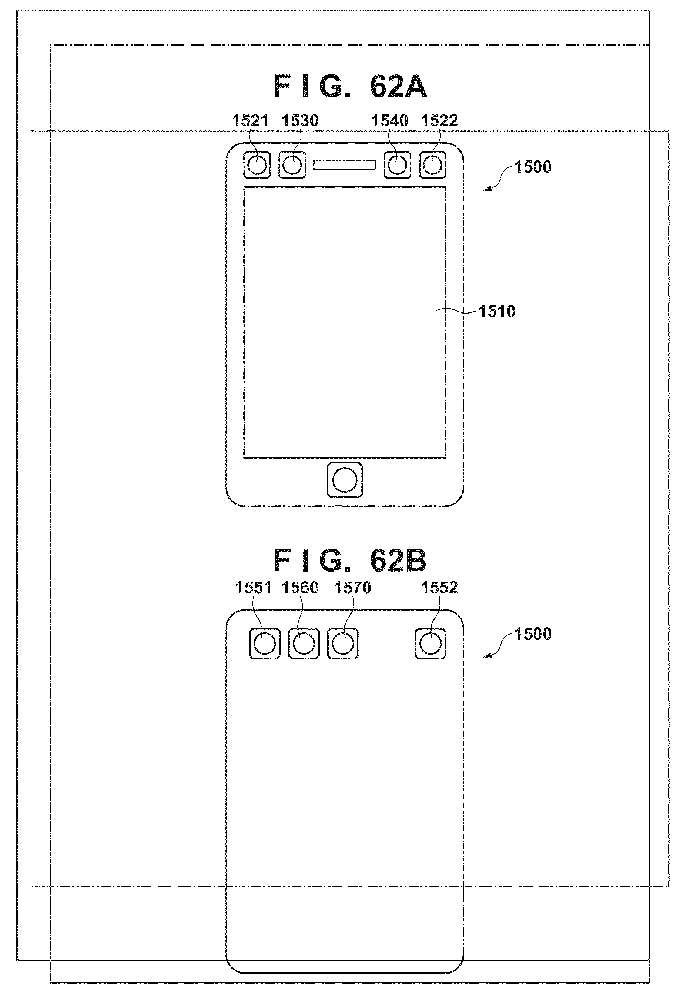

The sixth application example will be described with reference to Figs. 62A and 62B. The above-described photoelectric conversion apparatus and photoelectric conversion system may be applied to, for example, electronic equipment such as a so-called smartphone or tablet.

Figs. 62A and 62B are views showing an example of electronic equipment 1500 on which the photoelectric conversion apparatus is mounted. Fig. 62A shows the front surface side of the electronic equipment 1500, and Fig. 62B shows the back surface side of the electronic equipment 1500.

As shown in Fig. 62A, a display 1510 that displays an image is arranged at the center of the front surface of the electronic equipment 1500. Then, front cameras 1521 and 1522 for each of which the above-described photoelectric conversion apparatus 100 is used, an IR light source 1530 that emits infrared rays, and a visible light source 1540 that emits visible light are arranged along the upper side of the front surface of the electronic equipment 1500.

As shown in Fig. 62B, rear cameras 1551 and 1552 for each of which the above-described photoelectric conversion apparatus 100 is used, an IR light source 1560 that emits infrared rays, and a visible light source 1570 that emits visible light are arranged along the upper side of the back surface of the electronic equipment 1500.

By applying the above-described photoelectric conversion apparatus 100, the electronic equipment 1500 having the above arrangement can capture, for example, an image of higher quality. Note that the photoelectric conversion apparatus can be applied to electronic equipment such as an infrared sensor, a distance measurement sensor using an active infrared source, a security camera, or a personal or biometric authentication camera. This can improve the accuracy and performance of the electronic equipment.

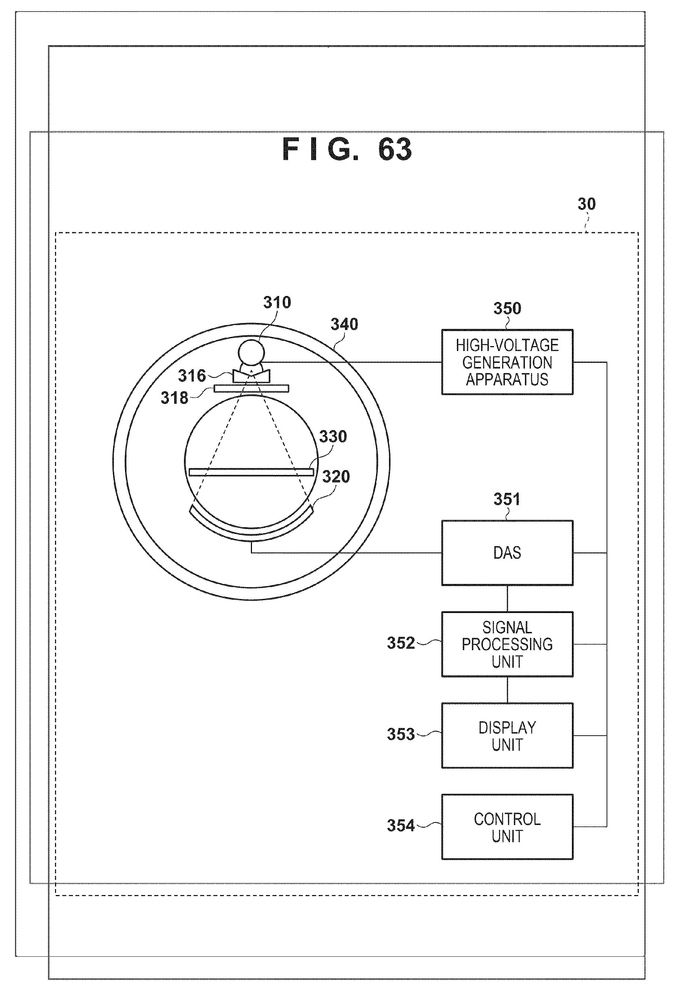

Fig. 63 is a block diagram of an X-ray CT apparatus according to the seventh application example. The above-described photoelectric conversion apparatus 100 is applicable to a detector of the X-ray CT apparatus. An X-ray CT apparatus 30 according to this application example includes an X-ray generation unit 310, a wedge 316, a collimator 318, an X-ray detection unit 320, a top plate 330, a rotating frame 340, and a high-voltage generation apparatus 350. The X-ray CT apparatus 30 also includes a Data Acquisition System (DAS) 351, a signal processing unit 352, a display unit 353, and a control unit 354.

The X-ray generation unit 310 is formed from, for example, a vacuum tube that generates X-rays. The vacuum tube of the X-ray generation unit 310 is supplied with a filament current and a high voltage from the high-voltage generation apparatus 350. When thermoelectrons are emitted from a cathode (filament) to an anode (target), X-rays are generated.

The wedge 316 is a filter that adjusts the amount of X-rays emitted from the X-ray generation unit 310. The wedge 316 attenuates the amount of X-rays so that the X-rays emitted from the X-ray generation unit 310 to an object has a predetermined distribution. The collimator 318 is formed from a lead plate that narrows the irradiation range of the X-rays having passed through the wedge 316. The X-rays generated by the X-ray generation unit 310 is formed in a cone beam shape via the collimator 318, and the object on the top plate 330 is irradiated with the X-rays.

The X-ray detection unit 320 is formed using the above-described photoelectric conversion apparatus 100. The X-ray detection unit 320 detects the X-rays having passed through the object from the X-ray generation unit 310, and outputs a signal corresponding to the amount of the X-rays to the DAS 351.

The rotating frame 340 is annular, and is configured to be rotatable. The X-ray generation unit 310 (the wedge 316 and the collimator 318) and the X-ray detection unit 320 are arranged to face each other in the rotating frame 340. The X-ray generation unit 310 and the X-ray detection unit 320 can rotate together with the rotating frame 340.

The high-voltage generation apparatus 350 includes a boosting circuit, and outputs a high voltage to the X-ray generation unit 310. The DAS 351 includes an amplification circuit and an A/D conversion circuit, and outputs, as digital data, a signal from the X-ray detection unit 320 to the signal processing unit 352.

The signal processing unit 352 includes a Central Processing Unit (CPU), a Read Only Memory (ROM), and a Random Access Memory (RAM), and can execute image processing and the like for the digital data. The display unit 353 includes a flat display apparatus or the like, and can display an X-ray image. The control unit 354 includes a CPU, a ROM, a RAM, and the like, and controls the operation of the overall X-ray CT apparatus 30.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion apparatus that comprises a semiconductor layer including a first surface and a second surface, a first electrode plug arranged to contact the first surface and supplied with a first voltage, and a second electrode plug arranged to contact the first surface and supplied with a second voltage, wherein
the semiconductor layer includes an active region defined by an isolation region so as to have an elongated shape in a predetermined direction in an orthogonal projection onto the first surface,
the active region includes a first semiconductor region of a first conductivity type arranged to contact the first electrode plug, and a second semiconductor region of a second conductivity type arranged to contact the second electrode plug, and
a centroid of the first semiconductor region is arranged between a first end of the active region in the predetermined direction and a centroid of the active region, and the second semiconductor region is arranged between a second end of the active region in the predetermined direction and the first semiconductor region.

2. The apparatus according to claim 1, wherein
a length of the active region in the predetermined direction is not less than 1.5 times and not more than 2.5 times a length of the active region in a direction orthogonal to the predetermined direction.

3. The apparatus according to claim 1 or 2, wherein
the apparatus has a structure in which a first substrate and a second substrate are bonded,
the first substrate includes the semiconductor layer, the first electrode plug, and a first joint portion electrically connected to the first electrode plug,
the second substrate includes a second joint portion joined to the first joint portion, and
in an orthogonal projection onto the first surface, the first joint portion and the second joint portion overlap the first semiconductor region.

4. The apparatus according to any one of claims 1 to 3, wherein
the isolation region is arranged to surround the active region,
the isolation region includes a first isolation region extending from the second surface toward the first surface, and a second isolation region extending from the first surface toward the first isolation region,
the first isolation region includes a pinning film, and
the second isolation region does not include a pinning film.

5. The apparatus according to any one of claims 1 to 4, further comprising a plurality of pixels,
wherein
each pixel includes the active region including the first semiconductor region and the second semiconductor region,
the plurality of pixels include a first pixel and a second pixel arranged adjacent to each other, and
a direction from the first semiconductor region of the first pixel toward the second semiconductor region of the first pixel matches a direction from the first semiconductor region of the second pixel toward the second semiconductor region of the second pixel.

6. The apparatus according to claim 5, wherein
the plurality of pixels form a plurality of sets such that two adjacent pixels form one set, and a plurality of microlenses are provided to correspond to the plurality of sets, respectively.

7. The apparatus according to claim 6, wherein
the two adjacent pixels are used to detect a phase difference, and
the plurality of sets are arranged to form a square grid.

8. The apparatus according to any one of claims 1 to 7, wherein
the first semiconductor region is arranged to fit in one of two regions obtained by dividing the active region equally in the predetermined direction.

9. The apparatus according to any one of claims 1 to 8, wherein
the active region further includes a third semiconductor region arranged to surround the first semiconductor region, and a fourth semiconductor region arranged between the third semiconductor region and the second surface,
the fourth semiconductor region is electrically connected to the second semiconductor region, and
an avalanche multiplication region is formed between the first semiconductor region and the fourth semiconductor region.

10. The apparatus according to claim 9, wherein
the isolation region is arranged to surround the active region,
the active region includes a fifth semiconductor region of the second conductivity type arranged to contact the isolation region, and
the fifth semiconductor region is arranged to surround the fourth semiconductor region.

11. The apparatus according to claim 10, wherein
the active region further includes a sixth semiconductor region of the second conductivity type arranged between the fourth semiconductor region and the second surface and spaced apart from the fourth semiconductor region, a seventh semiconductor region of the first conductivity type arranged between the fourth semiconductor region and the sixth semiconductor region, and an eighth semiconductor region of the first conductivity type at least partially surrounded by the seventh semiconductor region, and an impurity concentration of the first conductivity type in the eighth semiconductor region is higher than an impurity concentration of the first conductivity type in the seventh semiconductor region, and
in an orthogonal projection onto the first surface, the eighth semiconductor region at least partially overlaps the first semiconductor region.

12. The apparatus according to any one of claims 1 to 11, wherein
the active region further includes a ninth semiconductor region of the second conductivity type arranged to surround the second semiconductor region, and an impurity concentration of the second conductivity type in the ninth semiconductor region is lower than an impurity concentration of the second conductivity type in the second semiconductor region.

13. The apparatus according to any one of claims 1 to 12, wherein
the active region further includes a tenth semiconductor region of the first conductivity type, and an eleventh semiconductor region of the first conductivity type, and the tenth semiconductor region is arranged to electrically connect the first semiconductor region and the eleventh semiconductor region.

14. The apparatus according to claim 13, wherein
a distance between a centroid of the eleventh semiconductor region and a centroid of the active region is smaller than a distance between a centroid of the first semiconductor region and a centroid of the active region.

15. A photoelectric conversion system comprising:
a photoelectric conversion apparatus defined in any one of claims 1 to 14; and
a signal processing unit configured to process a signal output from the photoelectric conversion apparatus.
